# EUROPÄISCHE PATENTSCHRIFT

(11) **EP 3 071 877 B1**
(45) Veröffentlichungstag und Bekanntmachung des Hinweises auf die Patenterteilung: **07.03.2018**
(21) Anmeldenummer: 14798893.5
(22) Anmeldetag: 17.11.2014
(51) Int. Cl.: F21S 8/06, F21S 6/00, F21V 19/00, F21Y 115/15, F21Y 113/00

(54) **LEUCHTE UMFASSEND WENIGSTENS EIN OLED-LEUCHTMITTEL**
LAMP COMPRISING AT LEAST ONE OLED LIGHTING MEANS
APPAREIL D'ÉCLAIRAGE COMPRENANT AU MOINS UNE SOURCE LUMINEUSE DE TYPE OLED

(30) Priorität: 18.11.2013 DE 102013112694; 16.12.2013 DE 102013114129; 14.05.2014 DE 102014106799
(43) Veröffentlichungstag der Anmeldung: 28.09.2016
(73) Patentinhaber: emdedesign GmbH, 60389 Frankfurt (DE)
(72) Erfinder: EMDE, Thomas, 60389 Frankfurt am Main (DE); PETERSEN, Christoph, 35423 Lich (DE); MEIER, Jonathan, 60313 Frankfurt am Main (DE)
(74) Vertreter: Fritz, Edmund Lothar
(86) Internationale Anmeldenummer: PCT/EP2014/074738
(87) Internationale Veröffentlichungsnummer: WO 2015/071454

(56) Entgegenhaltungen:
- WO-A1-2011/124689
- WO-A1-2013/116623
- DE-A1-102011 107 642
- DE-A1-102012 007 727
- DE-U1-202006 005 427
- US-A1- 2013 147 398

## Beschreibung

Die vorliegende Erfindung betrifft eine Leuchte umfassend wenigstens ein flächig auf einer mindestens teilweise lichtdurchlässigen Trägerplatte aufliegendes als OLED-Panel ausgebildetes OLED-Leuchtmittel, wobei wenigstens zwei jeweils einem OLED-Panel zugeordnete Kontaktschuhe auf der der Licht abgebenden Seite abgewandten Rückseite der Trägerplatte befestigt sind, welche jeweils Mittel zur Kontaktierung jeweils eines Pols des OLED-Panels umfassen und wobei wenigstens ein Kontaktschuh eine Befestigungsvorrichtung aufweist, mittels derer das OLED-Panel an der Trägerplatte befestigt wird, vorzugsweise eine Klemmvorrichtung, mittels derer das OLED-Panel klemmend befestigt wird.

Organische LEDs, hierin nachfolgend als OLED bezeichnet sind bereits seit einigen Jahren bekannt und wurden bislang vorwiegend im Display-Bereich eingesetzt. Der Grund hierfür liegt darin, dass der von den OLEDs abgegebene Lichtstrom bis vor einiger Zeit für Zwecke der Allgemeinbeleuchtung nicht ausreichend war. OLEDs ließen sich daher lediglich für eine ergänzende Beleuchtung oder Effektbeleuchtung einsetzen. Zudem waren die Herstellkosten der OLEDs bis vor einigen Jahren so hoch, dass ein Einsatz für Zwecke der Allgemeinbeleuchtung nicht wirtschaftlich war. In jüngster Zeit wurden jedoch immer effektivere OLEDs mit steigender Lichtausbeute entwickelt und die Produktionskosten sind stetig gesunken.

Beispielsweise bietet die Fa. Philips unter der Bezeichnung "lumiblade GL 350" flache OLED-Panels an, die bei einer Größe von 124,5 x 124,5 mm einen Lichtstrom von 120 lumen weißes Licht liefern, was beispielsweise für eine Tischleuchte oder andere Anwendungen im Bereich von Wohnraumleuchten durchaus ausreichend ist (siehe Veröffentlichung im Internet unter http://www.lighting.philips.de/lightcommunity/trends/oled/lumibladeoledgl350.wpd.)

Bei OLED-Panels der genannten Art befindet sich in der Regel der eigentliche OLED-Stack auf einer Trägerplatte aus Glas oder Kunststoff. Wenn man ein derartiges OLED-Panel in eine Leuchte integrieren möchte, kommt grundsätzlich eine konstruktive Lösung in Betracht, bei der das OLED-Panel oder mehrere solcher OLED-Panels auf eine lichtdurchlässige Trägerplatte aufgebracht sind. Es müssen dabei jedoch noch einige technische Probleme gelöst werden, nämlich zum einen muss man eine Kontaktierung des OLED-Panels schaffen, um diese mit Strom zu versorgen und zum anderen muss man die OLEDs auf der Trägerplatte sicher befestigen. Schließlich sind gegebenenfalls lichttechnische Maßnahmen erforderlich, die eine effektive Lichtauskopplung des von den OLEDs abgegebenen Lichts und eine gleichmäßige Lichtverteilung über die lichtabstrahlende Fläche der Trägerplatte gewährleisten.

Aus der DE 10 2010 038 251 A1 ist ein OLED-Leuchtmittel in Form eines OLED-Panels bekannt geworden sowie eine Leuchte, die mehrere dieser OLED-Panels in einer matrixartigen Anordnung mit Reihen und Spalten aufweist. Jedem der OLED-Leuchtmittel sind mehrere Kontakte zugeordnet für die elektrische Kontaktierung des jeweiligen Leuchtmittels. Die Leuchte hat ein Gehäuse mit einem Rahmen, der das OLED-Panel an der Vorderseite randseitig einfasst und mit einer Gehäuserückwand, in der auch die Kontakte gehalten werden. Die Gehäuserückwand besteht aus einem nicht lichtdurchlässigen Kunststoff, da vorgesehen ist, dass der Lichtaustritt nur vorderseitig über die von dem Rahmen eingefasste Leuchtfläche erfolgt. An der Rückseite der Gehäuserückwand wird außerdem eine Fassung angebracht, über die man die Leuchte an Zuleitungen anschließen kann. Das OLED-Panel liegt somit bei dieser bekannten Leuchte zwischen dem vorderseitigen Rahmen und der lichtundurchlässigen Rückwand. Da jedes OLED-Panel an der Lichtaustrittsseite einen seine Leuchtfläche einfassenden Rahmen aufweist, ist bei einer matrixartigen Anordnung mehrerer solcher Leuchtmittel die gesamte Licht abgebende Fläche der Leuchte zwischen den Reihen und den Spalten jeweils durch die Stege der Rahmen der Leuchtmittel unterbrochen. Hier wird zwar eine Gesamtleuchtfläche geschaffen, indem mehrere gleichartige Leuchtmittel nebeneinander angeordnet werden, jedoch bleibt jedes Leuchtmittel eine Einheit für sich und es gibt keine gemeinsame Trägerplatte, auf der sich mehrere Leuchtmittel befinden.

In der DE 10 2011 077 687 A1 wird ein Modul (eine Leuchte) mit mehreren matrixartig in mehreren Reihen angeordneten OLED-Panels beschrieben, bei der eine Kontaktstruktur mittig zwischen zwei nebeneinander liegenden OLED-Panels angeordnet ist. Die OLED-Panels können im Umriss achteckig oder rechteckig sein. Kontaktbereiche entlang einer zugewandter Kanten der benachbarten OLED-Panels können über eine Feder der mittigen Kontaktstruktur elektrisch leitend verbunden werden. Jedes OLED-Panel hat jeweils ein eigenes Substrat, das als Träger dient für die erste Elektrodenschicht, die organische Schichtenfolge mit der Emitterschicht und die zweite Elektrodenschicht, wobei diese Schichtenfolge in der Fachwelt im allgemeinen als OLED-Stack bezeichnet wird. Die funktionellen Schichten jedes OLED-Panels sind oberseitig durch eine als Verkapselung dienende Glasplatte abgedeckt. Diese oberseitige verkapselte Fläche ist diejenige Fläche des OLED-Panels, an der der Lichtaustritt erfolgt. Wenn man somit das Substrat als Trägerplatte des einzelnen OLED-Panels ansieht, dann befindet sich diese Trägerplatte an der der Licht abgebenden Seite gegenüber liegenden Rückseite des OLED-Panels. Auch bei eng benachbarten OLED-Panels sind zudem die Trägerplatten der OLED-Panels voneinander getrennt, denn es handelt sich bei jedem OLED-Panel um eine autarke Einheit, welche ein Leuchtmittel für die Leuchte darstellt. Werden mehrere rechteckige OLED-Panels matrixartig in Reihen nebeneinander angeordnet, wird zum einen ein Grundrahmen mit Aussparungen als zusätzliche mechanische Halterung bereitgestellt und ein Deckrahmen wird auf dem Grundrahmen angeordnet und mit diesem mechanisch verbunden. Der Deckrahmen hat kreuzförmige Stege, die die mittig zwischen den benachbarten OLED-Panels liegenden Kontaktstrukturen abdecken. Insgesamt wird damit eine Lichtaustrittsfläche geschaffen, die durch die Stege von Grundrahmen und Deckrahmen in Längsrichtung und Querrichtung unterteilt ist. Bei den in dieser Druckschrift beschriebenen Varianten, bei denen achteckige OLED-Panel-Module aneinandergereiht werden, werden diese in ihren Randbereichen über beispielsweise stabförmige Verbindungselemente und Ösen miteinander verbunden. Es ist somit hier keine gemeinsame Trägerplatte vorgesehen, auf der mehrere OLED-Panels aufgebracht werden und die diesen als tragende Struktur dient.

In der US 2013/0076229 A1 ist ein flaches panelartiges OLED-Leuchtmittel-Modul beschrieben sowie eine dieses OLED-Leuchtmittel-Modul umfassende Leuchte. Das OLED-Leuchtmittel umfasst neben dem eigentlich Licht abgebenden Modul mit den OLED-Schichten einen mehrteiligen Befestigungsteil. Vor dem OLED-Panel befindet sich an der Licht abgebenden Seite eine transparente Abdeckung, während sich an der Rückseite ein Gehäuse aus einem nicht transparenten Material befindet, welches auch den vorderseitigen Deckel hält. Das geschlossene Gehäuse verhindert einen Lichtaustritt zur Rückseite des Moduls hin. Das Licht abgebende Modul ist von einem vergleichsweise breiten rechteckigen Rahmen eingefasst, der die Licht emittierende Fläche reduziert. Über den Rahmen erfolgt auch die Kontaktierung des OLED-Stacks. Bei diesem OLED-Leuchtmittel-Modul sind Maßnahmen getroffen, um von dem Licht abgebenden Modul in die transparente Abdeckung abgegebenes Licht in deren Randbereich durch Streuung oder Reflektion in die transparente Platte zurück zu lenken, um so auch eine gewisse Aufhellung im Randbereich zu erzielen. Es wird hier zwar ein Lichtverlust durch Totalreflektion in den überstehenden Randbereich der transparenten Platte verhindert, jedoch bleibt die effektive Fläche des mit ausreichender Lichtstärke Licht abgebenden Teils der OLED dabei gleich. In der Schrift wird keine technische Lösung beschrieben, wie man gegebenenfalls mehrere dieser OLED-Leuchtmittel-Module in einer Leuchte miteinander kombiniert. Da die Leuchtmittel-Module einen vergleichsweise breiten umlaufenden Rand haben, würde man bei Aneinanderreihung keine durchgehende Leuchtfläche erzielen. Wenn man die untere transparente Abdeckung des OLED-Leuchtmittel-Moduls als Trägerplatte für das Modul ansehen würde, dann wäre diese Trägerplatte nur einem einzigen Leuchtmittel zugeordnet, wobei die Seitenwände des rückseitigen Gehäuses die Trägerplatte sogar mit Abstand übergreifen. Eine durchgehende Trägerplatte für mehrere Leuchtmittel-Module ist bei dieser bekannten Lösung weder vorgesehen noch technisch sinnvoll möglich.

Aus der DE 10 2006 054 584 A1 ist ein Ablagemöbel bekannt mit einer Ablagefläche, die ein flächig ausgeformtes strahlungsemittierendes Bauelement in Form einer plattenförmigen OLED umfasst. Grundsätzlich ist es somit aus dieser Schrift bekannt, flächige plattenförmige Bereiche eines Möbelstücks über OLED-Panels zu beleuchten. Diese Druckschrift enthält jedoch keine Ausführungen darüber, wie man mehrere OLED-Panels in eine Ablagefläche bringt. Da derzeit die größten am Markt erhältlichen OLED-Panels der jüngsten Generation eine Größe von gut 120 mm x 120 mm aufweisen, ließe sich bei Verwendung nur einer OLED nur eine vergleichsweise kleine Ablagefläche eines Möbelstücks beleuchten.

In der DE 10 2004 026 730 A1 wird vorgeschlagen, flexible folienartige Flächen mit Hilfe von LEDs oder auch OLEDs zu beleuchten. Beispielsweise wird dabei eine transparente Folie in ein Rahmensystem eingehängt. In die Folie sind punktförmige Leuchtdioden jeweils mit Abstand zueinander in einer matrixartigen Anordnung eingebracht, wobei sie über sich kreuzende horizontal und vertikal verlaufende Drähte kontaktiert werden. Bei einer solchen Anordnung erhält man keine gleichmäßige flächige Lichtabstrahlung, sondern den Eindruck einer Vielzahl von Lichtpunkten. In diesem Dokument enthalten die Beispiele keine Ausführungsformen, bei denen mehrere flächige OLED-Panels zur Schaffung einer einheitlichen Leuchtfläche miteinander kombiniert werden.

Die DE 10 2011 079 014 A1 beschreibt Leuchtmodule in Form flächiger OLED-Panels. In dieser Schrift wird auch erwähnt, dass man aus mehreren solcher Leuchtmodule eine flächige Beleuchtungsanordnung schaffen kann, wobei man die einzelnen Leuchtmodule über elektrische Anschlüsse entweder in Reihe oder parallel miteinander verschaltet. Das OLED-Panel hat hier einen Aufbau mit einem aktiven Element, welches den Licht abgebenden OLED-Stack enthält und sandwichartig zwischen zwei Platten gehalten wird, nämlich einer Trägerplatte und einer zur Verkapselung dienenden Platte. Sowohl die Trägerplatte als auch das Verkapselungssubstrat können aus einem lichtdurchlässigen Material, beispielsweise Glas oder Kunststoff bestehen. In dieser Schrift wurde das grundsätzliche Problem der üblichen OLED-Panels erkannt, welche einen die Licht abgebende Fläche einfassenden Rahmen aufweisen, durch den die Fläche der effektiven Lichtabgabe eingeschränkt wird. Um den Rahmen schmaler ausbilden zu können, wird vorgeschlagen, die Leiterbahnen, die die elektrischen Anschlüsse zur Kontaktierung der OLED bilden, außen am Umfang an Stirnflächen des Panels anzuordnen. Durch den schmaleren Rahmen wird bei Kombination mehrerer OLED-Panels der Anteil nicht-leuchtender Flächen und Zwischenräume zwischen den Panels zwar reduziert, das grundsätzliche Problem der Unterbrechung durch nicht leuchtende Streifen bleibt jedoch bestehen. Diese Druckschrift offenbart keine konkrete Lösung, wie man durch Kombination mehrerer OLED-Panels eine durchgehende Leuchtfläche in einer Leuchte schafft. Es wird immer nur ein einzelnes OLED-Panel gezeigt, welches nur ein "Leuchtmittel" darstellt. Selbst wenn hier das einzelne Leuchtmittel eine transparente Trägerplatte aufweist, ist diese Trägerplatte nur diesem Leuchtmittel zugeordnet, mit der Verkapselungsplatte fest zu einer nicht lösbaren Einheit verbunden. Würde man die Verbindung zwischen Trägerplatte und Verkapselungsplatte eines solchen OLED-Panels lösen, würde die aktive OLED-Schicht der Atmosphäre ausgesetzt und durch Feuchtigkeit und Luftsauerstoff in ihrer Funktion und Lebensdauer beeinträchtigt. Das einzelne OLED-Panel mit sandwichartiger Anordnung von zwei Platten, die die aktive Licht abgebende Schicht einfassen, ist somit eine autarke nicht demontierbare Einheit, was der Konstrukteur einer Leuchte, bei der derartige OLED-Panels als Leuchtmittel verwendet werden, zu berücksichtigen hat. Verwendet man somit mehrere OLED-Panels dieser Art in einer Leuchte, weist jedes OLED-Panel eine eigene Trägerplatte auf, wobei die gesamte Materialstärke eines handelsüblichen OLED-Panels mit einem sandwichartigen Aufbau der vorgenannten Art beispielsweise bei ca. 1,8 mm liegt.

In der DE 10 2006 015 437 A1 wird eine Leuchtfliese beschrieben, die als Leuchtmittel mindestens eine OLED aufweist. Die Leuchtfliese hat einen Schichtaufbau mit einer rückseitigen Trägerplatte, einer vorderseitigen Sichtplatte, über die das Licht abgegeben wird und einem Zwischenraum zwischen beiden Platten, der die OLED-Schichten aufnimmt und nach außen hin abgedichtet ist. An der Rückseite der Leuchtfliese ist weiterhin ein elektrischer Anschluss vorgesehen, um die OLED zu kontaktieren. Zwar wird in der Schrift erwähnt, dass grundsätzlich mehrere OLEDs in einer Leuchtfliese verwendet werden können, jedoch wird keine konkrete technische Lösung gezeigt, die diese Idee verwirklicht. Die Trägerplatte, auf der die OLED-Schichten aufgebracht sind, ist hier die rückseitige nicht transparente Platte der Leuchtfliese. Würde man mehrere solcher Leuchtfliesen nebeneinander anordnen, ergäben sich wiederum unbeleuchtete Flächen zwischen den Fliesen, da die wirksame Licht abgebende Fläche auch hier um einiges kleiner ist als die Fläche der Leuchtfliese insgesamt.
In der DE 10 2011 107 642 A1 ist ein weiteres OLED-Leuchtmittel beschrieben. Dieses hat eine sichtseitige Trägerplatte aus Glas, über deren Oberfläche das Licht emittiert wird. Auf die Rückseite der Trägerplatte sind die OLED-Schichten aufgebracht, wobei sich hinter der Trägerplatte eine Abdeckplatte befindet, so dass die OLED-Schichten zwischen Trägerplatte und Abdeckplatte liegen. Hinter der Abdeckplatte befindet sich weiterhin ein plattenförmiger Kühlkörper, über den die Wärme abgeführt werden soll. Die gesamte Anordnung ist in ein Isolierstoffgehäuse eingefasst, in dem auch Kontaktwinkel mit zwei Schenkeln gehalten sind, deren einer Schenkel eine metallische Schicht im Randbereich der Trägerplatte kontaktiert. Durch den nicht transparenten Kühlkörper ist die Lichtabgabe nur zu einer Seite hin möglich. Das Isolierstoffgehäuse bildet einen vergleichsweise breiten Rahmen, der die Licht abgebende Fläche des OLED-Leuchtmittels um Umfang allseits einfasst, so dass bei einer Kombination mehrerer OLED-Leuchtmittel dieser Art keine durchgehende Leuchtfläche geschaffen werden kann. Diese Druckschrift gibt auch keine Anregung zur Schaffung einer Leuchte unter Verwendung mehrerer OLED-Leuchtmittel dieser Art. Es wird hier lediglich eine Lösung vorgestellt, um eine mit einem OLED-Stack beschichtete Trägerplatte zu fassen und zu kontaktieren. Daraus resultiert wiederum ein einzelnes OLED-Leuchtmittel, wobei hier eine individuelle Lösung für ein weiteres OLED-Leuchtmittel beschrieben wird. In der US2013/0147393 ist eine weitere OLED-Leuchte beschrieben. Am Markt sind jedoch OLED-Panels einiger weniger führender Leuchtmittel-Anbieter bekannt, die vorgegebene konstruktive Merkmale für die Kontaktierung, Fassung etc. aufweisen, so dass es für den Leuchtenkonstrukteur vorteilhaft ist, bei der Konstruktion einer Leuchte auf Basis von OLED-Leuchtmitteln die Gegebenheiten dieser am Markt erhältlichen OLED-Leuchtmittel zu berücksichtigen, anstatt ein weiteres individuelles OLED-Leuchtmittel zu schaffen.
Die Aufgabe der vorliegenden Erfindung besteht darin, eine Leuchte unter Verwendung von OLED-Panels als Leuchtmittel mit den Merkmalen der eingangs genannten Gattung zu schaffen, welche wenigstens eine durchgehende Leuchtfläche ohne Unterbrechungen mit weitgehend einheitlicher Lichtabgabe über die Leuchtfläche aufweist, wobei die Abmessungen der Leuchtfläche nicht auf die Abmessungen eines einzelnen OLED-Leuchtmittels beschränkt sind.

Weiterhin ist es ein Anliegen der vorliegenden Erfindung, eine Leuchte zu schaffen, die konstruktiv vergleichsweise einfach aufgebaut ist, ein ansprechendes Design hat und den zuvor genannten technischen Anforderungen genügt.

Die Lösung der vorgenannten Aufgabe liefert eine Leuchte umfassend wenigstens ein flächig auf einer mindestens teilweise lichtdurchlässigen Trägerplatte aufliegendes als OLED-Panel ausgebildetes OLED-Leuchtmittel der eingangs genannten Gattung mit den Merkmalen des Anspruchs 1.

Erfindungsgemäß sind zwei oder mehrere etwa in einer Reihe angeordnete OLED-Panels auf der der Licht abstrahlenden Seite abgewandten Rückseite der mindestens teilweise lichtdurchlässigen Trägerplatte angeordnet und wenigstens ein Kontaktflansch ist auf oder an der Trägerplatte befestigt, der mit einer auf der Trägerplatte aufgebrachten Leiterbahn in leitendem Kontakt steht, welche von dem Kontaktflansch aus zu einem oder mehreren jeweils den OLED-Panels zugeordneten Kontaktschuhen führt.

Die wenigstens zwei jeweils einem OLED-Panel zugeordneten Kontaktschuhe sind auf der der Licht abgebenden Seite abgewandten Rückseite der Trägerplatte befestigt und umfassen jeweils Mittel zur Kontaktierung jeweils eines Pols des OLED-Panels. Ein solcher Kontaktschuh kann jeweils mit dem minus-Pol der OLED und der andere mit dem plus-Pol der OLED in leitender Verbindung stehen, wobei die Kontaktschuhe über eine geeignete elektrische Verbindung mit Spannung versorgt werden können.

Wenigstens ein Kontaktschuh weist eine Befestigungsvorrichtung auf, mittels derer das OLED-Panel an der Trägerplatte befestigt wird, vorzugsweise eine Klemmvorrichtung, mittels derer das OLED-Panel klemmend befestigt wird. Auf diese Weise kann man die Kontaktschuhe in doppelter Funktion benutzen, nämlich einmal für die elektrische Versorgung der OLED-Panels und zum anderen für die Befestigung der OLED-Panels auf der Trägerplatte. Diese Lösung ist konstruktiv einfach und effektiv und ermöglicht eine rationelle Fertigung einer solchen OLED-Leuchte.

Gemäß einer Weiterbildung der Erfindung kann man beispielsweise über ein plattenförmiges Element des Kontaktschuhs wie zum Beispiel eine Platine oder dergleichen jeweils einen Pol der OLED kontaktieren. Für die elektrische Zuleitung zu den Kontaktschuhen, die sich an den OLED-Panels befinden, kann man beispielsweise auf die Trägerplatte aufgedruckte Leiterbahnen verwenden, wobei diese Technik der aufgedruckten Leiterbahnen aus anderen Bereichen der Lichttechnik an sich bekannt ist.

Gemäß einer Weiterbildung der Erfindung ist es vorteilhaft, wenn für jedes OLED-Panel jeweils eine diesem zugeordnete Konstantstromquelle oder ein Strombegrenzer vorgesehen ist. Bei dieser Variante ist es möglich, jeweils eine von einem plus-Pol und eine von einem minus-Pol einer Spannungsquelle kommende gemeinsame Zuleitung zu einem Kontaktelement auf der Trägerplatte der Leuchte zu leiten und dann von diesem aus beispielsweise die jeweiligen Leiterbahnen zu den parallel geschalteten OLED-Panels abzuzweigen, wobei in jeder Zweigleitung dem OLED-Panel jeweils die Konstantstromquelle oder der Strombegrenzer vorgeschaltet ist. Dadurch ist das OLED-Panel gegen zu hohe Ströme geschützt, aber bis zur Trägerplatte müssen nur insgesamt zwei Leitungen vom plus-Pol bzw. minus-Pol der Spannungsquelle geführt werden. Wollte man hingegen von der Spannungsquelle jeweils zwei Leitungen zu jedem OLED-Panel führen, würde man zu viele Leitungen benötigen und für einen derartigen Kabelbaum ist im Bereich der Zuleitung bei einer Leuchte des erfindungsgemäßen Typs kein ausreichender Platz vorhanden.

Vorzugsweise ist gemäß einer Weiterbildung der Erfindung für jedes OLED-Panel jeweils eine Überwachungselektronikschaltung vorgesehen. Eine solche Überwachungselektronikschaltung kann beispielsweise jeweils im Leitungsweg zwischen Konstantstromquelle oder Strombegrenzer und den Kontakten des OLED-Panels angeordnet werden. Gemäß einer konstruktiven Ausführungsvariante der Erfindung kann beispielsweise die Überwachungselektronikschaltung eine Schaltung zur Überwachung der Vorwärtsspannung der OLED und/oder eine Auslöseverzögerung und/oder einen Bypass-Thyristor umfassen.

Konstruktiv kann man die Kontaktierung der OLED-Panels beispielsweise so lösen, dass die Zuleitung von dem plus-Pol der Spannungsquelle zu einem ersten Kontaktflansch führt, der auf oder an der Trägerplatte befestigt ist und der mit einer auf der Trägerplatte aufgebrachten ersten Leiterbahn in leitendem Kontakt steht und dass ein zweiter Kontaktflansch auf oder an der Trägerplatte befestigt ist, der mit einer vom minus-Pol der Spannungsquelle kommenden, auf der Trägerplatte aufgebrachten, zweiten Leiterbahn in leitendem Kontakt steht, wobei für jedes OLED-Panel in Parallelschaltung jeweils eine mit der ersten Leiterbahn und mit der zweiten Leiterbahn verbundene Zweigleitung in Form einer Leiterbahn jeweils zunächst zu einer diesem OLED-Panel zugeordneten Konstantstromquelle oder einem Strombegrenzer geführt ist und von dieser aus jeweils zwei Leiterbahnen zu den beiden Kontakten des OLED-Panels führen.

Ein weiteres Problem derartiger Leuchten mit OLED-Panels liegt darin, dass man bei Verwendung mehr oder weniger transparenter oder transluzenter Trägerplatten als Träger für die OLED-Panels die Befestigungselemente sowie die Elemente für die Kontaktierung der OLEDs an der Licht abgebenden Seite durch die Trägerplatte hindurch sehen könnte, was das ästhetische Erscheinungsbild der Leuchte stört. Deshalb verwendet man bei bekannten Lösungsansätzen zumeist Rahmenelemente zum Beispiel aus Metall oder Kunststoff um diese Befestigungselemente und Kontaktierungselemente der OLED-Panels zu kaschieren. Derartige Rahmenelemente führen jedoch zu einem komplexeren Aufbau der Leuchte, erfordern zusätzlichen Montageaufwand beim Hersteller und vergrößern gegebenenfalls auch die Aufbauhöhe und die Gesamtmaße der Leuchte, wodurch der besondere Vorteil der Flachheit der OLED-Panels wieder teilweise verloren geht.

Deshalb sieht eine Weiterbildung der vorliegenden Erfindung vor, dass die genannten Befestigungselemente und Kontaktierungselemente mit konstruktiv vergleichsweise einfachen Mitteln kaschiert werden, wobei weiterhin eine geringe Aufbauhöhe der Leuchte erzielt werden kann. Dazu ist die Trägerplatte an der der Licht abstrahlenden Seite abgewandten Rückseite in denjenigen Teilbereichen beschichtet, beklebt, mattiert oder bedruckt, in denen sich Befestigungselemente, insbesondere für die Aufhängung oder Halterung der Leuchte, und/oder Kontaktelemente für die OLED-Panels und/oder Leiterbahnen befinden. Auch die elektronischen Bauelemente wie Konstantstromquelle, Strombegrenzer, Überwachungselektronikschaltung etc. können auf diese Weise durch Bedruckung, Beschichtung etc. der Trägerplatte kaschiert werden.

Eine besonders vorteilhafte Weiterbildung der Erfindung sieht vor, dass die Trägerplatte an der der Licht abstrahlenden Seite abgewandten Rückseite mit wenigstens einer Schicht rahmenartig flächig bedruckt, beschichtet, beklebt oder mattiert ist, wobei diese Bedruckung, Beklebung, Mattierung oder Beschichtung die Licht abgebenden Flächen, auf denen das oder die OLED-Panels aufgebracht werden, ausspart.

Vorzugsweise erfolgt im Rahmen der Erfindung wenigstens eine Bedruckung, Beklebung oder Beschichtung mit keramischen Pigmenten oder einem anderen elektrisch isolierenden Farbmaterial, wodurch die so bedruckte Rückseite der Trägerplatte weiterhin elektrisch isolierend ist und somit anschließend Leiterbahnen aus einem elektrisch leitenden Pigment auf die so bedruckte Trägerplatte aufgedruckt oder geklebt werden können, die dazu dienen, die elektrische Verbindung zu den OLED-Panels herzustellen.

Weiterhin erfolgt vorzugsweise gemäß einer Weiterbildung der Erfindung wenigstens eine Bedruckung, Beklebung oder Beschichtung mit hellen, insbesondere etwa weißen Pigmenten oder Farbstoffen. Man kann die Rückseite der Trägerplatte auch in mehreren aufeinanderfolgenden Druckvorgängen bevorzugt jeweils deckungsgleich bedrucken, bekleben, mattieren oder beschichten beispielsweise mindestens zweifach jeweils mit hellen, insbesondere etwa weißen Pigmenten oder Farbstoffen.

Eine besonders bevorzugte Variante der vorliegenden Erfindung sieht vor, dass man die Rückseite der Trägerplatte in zwei oder mehreren aufeinanderfolgenden Druckvorgängen mit jeweils unterschiedlich farbigen Pigmenten oder Farbstoffen bedruckt, beklebt oder beschichtet, vorzugsweise jeweils deckungsgleich und rahmenartig jeweils unter Aussparung derjenigen Flächen an denen später die Licht abgebenden Flächen der OLED-Panels angeordnet werden. Beispielsweise kann sich um eine zweifache, dreifache oder mehrfache Bedruckung, Beklebung oder Beschichtung etwa der gleichen (deckungsgleichen) Flächen handeln, wobei wenigstens eine Bedruckung, Beklebung oder Beschichtung mit einem hellen, insbesondere weißen Pigment oder Farbstoff erfolgt und weiterhin, bevorzugt danach, wenigstens eine Bedruckung, Beklebung oder Beschichtung mit einem dunklen, insbesondere grauen oder schwarzen Pigment oder Farbstoff erfolgt. Bei dieser Art der zweifachen oder mehrfachen Bedruckung, Beklebung, Mattierung oder Beschichtung wird eine bessere Deckung der Trägerplatte gegen Durchsicht von der Vorderseite (Licht abgebenden Seite) her in den bedruckten/beschichteten/beklebten/mattierten Flächenbereichen erzielt und ein höherer Kontrast.

Man kann auch beispielsweise an der der Licht abstrahlenden Seite abgewandten Rückseite und/oder auch an der Licht abgebenden Seite der Trägerplatte zumindest teilweise eine Bedruckung, Beklebung, Mattierung, Beschichtung, Prägung oder Gravur in Flächenbereichen vorsehen, die die Randbereiche der Licht emittierenden Fläche der OLED-Panels und an diese angrenzende Bereiche umfassen. Auf diese Weise kann man eine gleichmäßigere Lichtverteilung an der Lichtaustrittsseite erzielen, da die Übergänge von hell zu dunkel bei eingeschalteter OLED in diesen Flächenbereichen weniger scharf (weicher) werden.

Vorteilhaft bei einer erfindungsgemäßen Leuchte ist auch, dass diese mit sehr wenigen funktionellen Bauteilen auskommt und die Art der Leuchtmittel und die Bedruckung der Trägerplatte, durch die Leuchtmittel quasi rahmenlos eingefasst sind, einen extrem flachen Aufbau der Leuchte ermöglichen. Man kann beispielsweise eine dünne Trägerplatte aus Glas oder Kunststoffglas verwenden, auf die man unmittelbar die sehr flachen OLED-Panels aufbringt, die nur eine Materialstärke von beispielsweise im 1 bis 2 mm-Bereich aufweisen. Die Bedruckung, Beklebung oder Beschichtung trägt nur vernachlässigbar auf, da sie selbst bei mehrfacher Bedruckung, Beklebung oder Beschichtung beispielsweise im µ-Bereich liegen kann.

Gegebenenfalls deckt man die OLED-Panels auf der der Licht abstrahlenden Seite abgewandten Seite der Trägerplatte mittels einer plattenförmigen Abdeckung ab, wenn dies zum Beispiel aus optischen Gründen gewünscht ist. Eine solche Abdeckung kann beispielsweise aus Metall oder anderen geeigneten Materialien wie Glas, Kunststoff, Papier, Leder oder Verbundmaterialien aus Kombinationen der vorgenannten Materialien bestehen und die Abdeckung kann in geringem Abstand zur Trägerplatte angebracht werden und ebenfalls sehr dünn sein, so dass sie die gesamte Bauhöhe der Leuchte nicht wesentlich erhöht.

Wenn zur Kontaktierung der OLED-Panels auf die Trägerplatte Leiterbahnen aufgebracht sind, kann beispielsweise wenigstens ein Kontaktschuh auf eine Leiterbahn unter Herstellung einer leitenden Verbindung aufgelötet oder aufgeklebt sein.

Es können auch weitere Leiterbahnen auf die Trägerplatte aufgebracht werden, so dass zusätzliche elektronische Bauelemente wie zum Beispiel Treiber, Sensoren etc. auf diese weiteren Leiterbahnen aufgelötet oder geklebt werden können. Diese elektronischen Bauelemente können zum Beispiel eine bestimmte Funktion haben für eine Schaltfläche der Leuchte. Beispielsweise können Ein- Ausschalter oder Dimmschalter vorgesehen sein, die vorzugsweise über berührungskapazitive Elemente oder Näherungssensoren betätigt werden. Ziel ist es dabei, einen nahezu unsichtbaren Bereich als Interface zu schaffen. Durch Berührung oder Näherung dieser Schaltflächen lässt sich zum Beispiel die Helligkeit des OLED-Panels dimmen und/oder schalten. Man kann also beispielsweise eine Art auf die Trägerplatte aufgedruckte Platine schaffen. Auch die genannten elektronischen Bauelemente können durch die vorgenannte Bedruckung, Beklebung, Mattierung oder Beschichtung kaschiert werden, so dass sie an der Licht abgebenden Seite der Trägerplatte für den Betrachter nicht sichtbar sind.

Man kann an den den OLED-Panels abgewandten Enden der Leiterbahnen wenigstens einen Kontaktflansch auf oder an der Trägerplatte befestigen, der mit einer auf der Trägerplatte aufgebrachten Leiterbahn in leitendem Kontakt steht, welche von dem Kontaktflansch aus zu einem oder mehreren jeweils den OLED-Panels zugeordneten Kontaktschuhen führt. Ein solcher Kontaktflansch, der mit wenigstens einer auf der Trägerplatte aufgebrachten Leiterbahn in leitendem Kontakt steht, kann im Bereich der Aufhängung oder Befestigung der Leuchte angeordnet sein. Bei dieser beispielhaften konstruktiven Ausführungsvariante einer solchen Leuchte erfolgt somit die elektrische Zuleitung zunächst beispielsweise von einem der Leuchte zugeordneten Netzteil über die Befestigung zu den Kontaktflanschen und von diesen über die Leiterbahnen zu den Kontaktschuhen, die wiederum die OLED-Panels kontaktieren. Besonders vorteilhaft ist, dass man hier Bauteile, die der Befestigung der Leuchte, der Trägerplatte und der OLED-Panels dienen, quasi in zusätzlicher Funktion für die Versorgung der OLEDs mit Spannung verwendet.

Vorzugsweise besteht mindestens die dem OLED-Panel zugewandte und mit diesem zu verbindende Fläche der lichtdurchlässigen Trägerplatte aus Glas oder Kunststoffglas, insbesondere Acrylglas und ebenso besteht vorzugsweise eine der lichtdurchlässigen Trägerplatte zugewandte und mit dieser lösbar zu verbindende Trägerschicht des OLED-Panels aus Glas oder Kunststoffglas, insbesondere Acrylglas.

Gemäß einer bevorzugten Weiterbildung der erfindungsgemäßen Aufgabenlösung ist die lichtdurchlässige Trägerplatte, auf der ein oder mehrere OLED-Panels angebracht werden, Teil einer Pendelleuchte, Hängeleuchte, Deckenanbauleuchte, Deckeneinbauleuchte, Wandanbauleuchte, Wandeinbauleuchte, Stehleuchte oder Tischleuchte. Die der Licht abgebenden Seite abgewandte Rückseite der Trägerplatte gemäß obiger Definition ist beispielsweise bei einer Pendelleuchte die Oberseite der Trägerplatte. Erfindungsgemäß sind somit bei einer Pendelleuchte ein oder mehrere OLED-Panels auf der Oberseite der mindestens teilweise lichtdurchlässigen Trägerplatte angeordnet.

Weitere alternative Varianten der erfindungsgemäßen Leuchten können zum Beispiel Bodeneinbauleuchten, Spiegelleuchten, Möbelleuchten oder beleuchtbare Möbelelemente, mobile Leuchten, Außenleuchten, Straßenleuchten, Orientierungsleuchten, Hinweisleuchten, oder Leuchten für eine Notbeleuchtung sein. Weitere mögliche Anwendungen für die erfindungsgemäßen Leuchten liegen beispielsweise im Bereich der Signalvorrichtungen (beispielsweise Ampeln), als Displays für Fassadenelemente, als Einbauvorrichtungen in Kraftfahrzeugen, Schienenfahrzeugen, Schiffen, Flugzeugen oder dergleichen.

Die Spannungsversorgung kann bei einer solchen Pendelleuchte beispielsweise über die Aufhängung der Leuchte erfolgen, die an ihrem unteren Ende mechanisch mit der Trägerplatte verbunden wird. Von dort aus kann man beispielsweise über einen Kontaktflansch der Aufhängung eine elektrisch leitende Verbindung mit einer Leiterbahn herstellen, welche wiederum auf das Glas oder Acrylglas der Trägerplatte aufgedruckt werden kann und von dem Kontaktflansch der Aufhängung aus zu einem der oben genannten Kontaktschuhe geführt wird, welcher wiederum das OLED-Panel kontaktiert.

Gemäß einer bevorzugten Weiterbildung der Erfindung ist die Trägerplatte an ihrer Licht abstrahlenden Seite mindestens in Teilbereichen mattiert, insbesondere durch Ätzen, Sandstrahlen, Schleifen, Lasern oder dergleichen. Dadurch kann man eine gleichmäßigere Lichtverteilung erzielen. Das Licht wird dann nicht nur in den exakt den Leuchtflächen der OLED-Panels entsprechenden Bereichen abgestrahlt und die diskreten Umrisse der Leuchtflächen werden vom Betrachter nicht mehr oder weniger ausgeprägt wahrgenommen. Bei Verwendung mehrerer OLED-Panels kann quasi die gesamte Fläche der Trägerplatte an ihrer Licht abgebenden Seite Licht abstrahlend sein.

An der der Licht abstrahlenden Seite abgewandten Rückseite kann beispielsweise die Trägerplatte mindestens in Teilbereichen beschichtet oder bedruckt sein, um die Lichtabstrahlcharakteristik oder die Lichtfarbe zu verändern, oder um beispielsweise eine Lichtabgabe oder eine veränderte Lichtabgabe nur in selektiven Flächenbereichen zu erzielen. Eine solche Beschichtung kann teilweise lichtdurchlässig sein und deren Aufbringung kann durch Bedruckung beispielsweise durch Siebdruck oder Digitaldruck oder andere geeignete Druckverfahren erfolgen.

Alternativ dazu kann die Beschichtung mittels einer der gängigen im Stand der Technik bekannten Methoden zur Aufbringung dünner Schichten erfolgen, beispielsweise durch Vakuum-Beschichtung, Verdampfung (PVD), Sputtern, Plasmabeschichtung, Gasphasenabscheidung (CVD), Sol-Gel-Abscheidung, Schleuderbeschichtung, Walzenauftrag, Sprühen, Tauschbeschichtung etc.

Man kann beispielsweise eine selektive Lichtstreuung der Trägerplatte in bestimmten Flächenbereichen durch Bedrucken, Lasern, Sandstrahlen, Schleifen, Fräsen, Ätzen oder dergleichen der Trägerplatte an deren Licht abgebender Seite erzielen, um dort eine erhöhte Lichtauskopplung oder beispielsweise eine gleichmäßigere Lichtauskopplung in den Randbereichen der OLED-Panels zu bewirken. Eine Beschichtung der Trägerplatte an der der Lichtabgabe abgewandten Seite kann teilweise oder vollflächig erfolgen, zum Beispiel auch zur Aufbringung einer Verspiegelung.

Durch die Bedruckung oder Beschichtung kann man erreichen, dass sich im ausgeschalteten Zustand der Bereich oder die Bereiche, in welchen sich die sichtbare Lichtaustrittsfläche der OLED-Panels befinden bzw. befinden, in ihrer Farbe und/oder in ihrem Erscheinungsbild nur wenig von dem restlichen Bereich der Trägerplatte unterscheiden und man somit eine weitgehend homogen erscheinende sichtbare Fläche erhält, welche eine ansprechende optische Erscheinung der erfindungsgemäßen Leuchte gewährleistet.

Eine erfindungsgemäße Leuchte kann zwei oder mehrere OLED-Panels aufweisen. Meist haben die OLED-Panels einen etwa rechteckigen Umriss, aber auch andere Umrissformen sind denkbar. Verwendet man zwei oder mehrere OLED-Panels, kann man diese beispielsweise etwa in einer Reihe oder in mehreren Reihen nebeneinander anordnen, wobei in der Regel die OLED-Panels auf der der Licht abstrahlenden Seite abgewandten Rückseite der mindestens teilweise lichtdurchlässigen Trägerplatte angeordnet sind und beispielsweise jeweils ein Pol dieser in einer Reihe angeordneten OLED-Panels von je einer gemeinsamen Leiterbahn kontaktiert werden kann.

Es gibt weiterhin OLED-Panels mit anderen Umrissformen wie beispielsweise runde oder ovale OLED-Panels mit einer runden, dreieckigen oder rechteckigen Lichtabgabefläche in unterschiedlichsten Größen. Die erfindungsgemäße Bedruckung oder Beschichtung kann dem jeweiligen OLED-Panel Format angepasst werden entsprechend der Kontur der Licht abgebenden Fläche.

Man kann die OLED-Panels parallel oder in Serie schalten. Im letztgenannten Fall verbinden Leiterbahnen jeweils die unterschiedlichen Pole eines OLED-Panels.

Neben den vorgenannten Anwendungen sind weitere Anwendungsbereiche für die erfindungsgemäßen Leuchten denkbar. Beispielsweise kann die Leuchte ein Leuchtregal, Leuchtpanel, elektrisches Gerät, Haushaltsgerät, Stadtraummöbel, Fassadenelement, Wandelement, Deckenelement, eine Außenleuchte eines Kraftfahrzeugs oder eine Einbaueinrichtung eines Kraftfahrzeugs, Schienenfahrzeugs, Schiffs oder Flugzeugs ist, oder ein beleuchtbares Teil eines solchen Gegenstands sein.

Gegenstand der vorliegenden Erfindung ist weiterhin eine alternative Lösungsvariante, bei der man ohne Leiterbahnen auf der Trägerplatte auskommt. Bei dieser Variante einer Leuchte mit den Merkmalen der eingangs genannten Gattung sind ebenfalls zwei oder mehrere etwa in einer Reihe angeordnete OLED-Panels auf der der Licht abstrahlenden Seite abgewandten Rückseite einer mindestens teilweise lichtdurchlässigen Trägerplatte angeordnet und es ist auch wenigstens ein Kontaktflansch auf oder an der Trägerplatte befestigt, jedoch steht dieser Kontaktflansch unmittelbar mit einem auf der Trägerplatte angeordneten Kontaktschuh in elektrisch leitendem Kontakt, welcher wiederum außerdem wenigstens ein OLED-Panel kontaktiert. Es sind hier somit keine Leiterbahnen zwischen Kontaktflansch und Kontaktschuhen notwendig. Kontaktflansch und wenigstens ein Kontaktschuh liegen in relativer räumlicher Nähe zueinander.

Vorzugsweise ist bei dieser Variante wenigstens ein Kontaktschuh vorgesehen, der jeweils die Kontaktbereiche zweier benachbarter OLED-Panels kontaktiert, wobei bei einem OLED-Panel der plus-Pol und bei dem anderen OLED-Panel der minus-Pol kontaktiert wird. Es handelt sich also hier um eine Reihenschaltung der OLED-Panels, bei der der Stromfluss von einem Kontaktflansch des einen Pols, in dessen Bereich die Einspeisung des Stroms in die Leuchte erfolgen kann, über einen Kontaktschuh in ein erstes OLED-Panel, von diesem wiederum über einen weiteren Kontaktschuh in das nächste OLED-Panel usw. bis zu einem weiteren Kontaktflansch des anderen Pols erfolgen kann.

Bei dieser Variante kann gemäß einer bevorzugten Weiterbildung der Erfindung wenigstens ein Kontaktschuh insbesondere zweiteilig ausgebildet sein und ein auf der Trägerplatte festlegbares Klemmelement umfassen und wenigstens ein mit dem Klemmelement lösbar verbindbares Kontaktelement, welches den Kontaktbereich des (der) OLED-Panels kontaktiert.

Bei dieser Variante der Erfindung können beispielsweise die OLED-Panels sich entlang einer Kante erstreckende etwa leistenförmige oder zungenartige Kontaktbereiche aufweisen und wenigstens ein Kontaktelement kann im montierten Zustand von oben auf diesen Kontaktbereich drücken und dabei das OLED-Panel gleichzeitig kontaktieren und auf der Trägerplatte festklemmen. So löst man mit vergleichsweise einfachen technischen Mitteln die lösbare Befestigung der OLED-Panels auf der Trägerplatte und gleichzeitig die Kontaktierung der OLED-Panels. Dabei kann zum Beispiel das Klemmelement fest auf der Trägerplatte montiert sein und das Kontaktelement einerseits unter einen Bereich des Klemmelements und andererseits über den leistenförmigen Kontaktbereich des OLED-Panels geschoben werden.

Die in den Unteransprüchen genannten Merkmale beziehen sich auf bevorzugte Ausführungsformen der Erfindung. Weitere Vorteile der Erfindung ergeben sich aus der nachfolgenden Detailbeschreibung.

Nachfolgend wird die vorliegende Erfindung anhand von Ausführungsbeispielen unter Bezugnahme auf die beiliegenden Zeichnungen näher erläutert. Dabei zeigen:
Figur 1 eine schematisch vereinfachte perspektivische Ansicht einer beispielhaften erfindungsgemäßen Pendelleuchte von schräg unten her gesehen;
Figur 2 eine weitere schematisch vereinfachte perspektivische Ansicht einer erfindungsgemäßen Pendelleuchte von schräg oben her gesehen;
Figur 3 eine schematisch vereinfachte Draufsicht einer beispielhaften Ausführungsvariante einer Pendelleuchte von Figur 1 und 2;

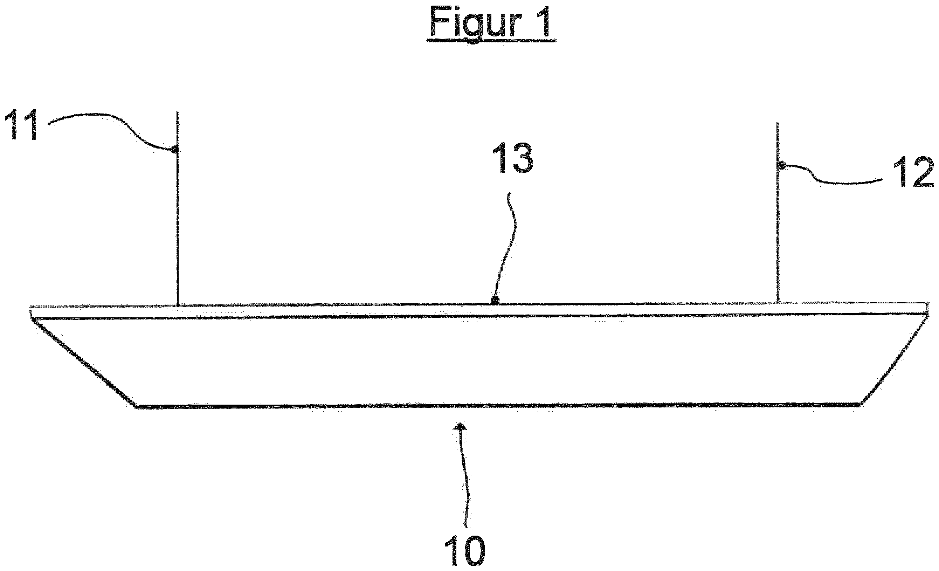

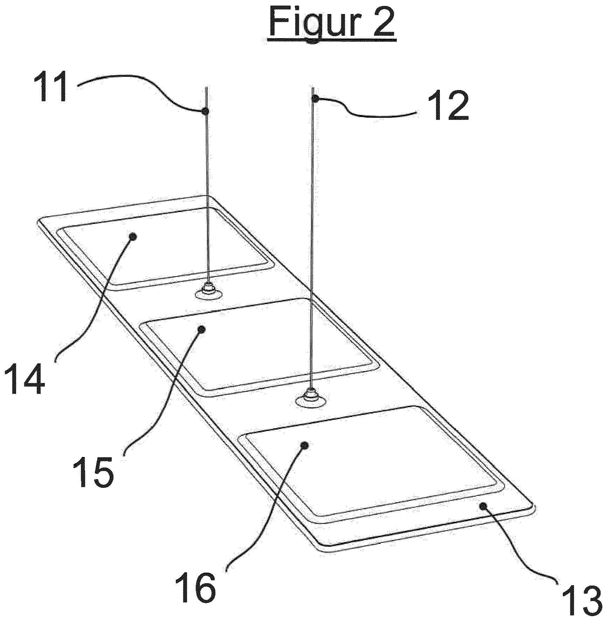

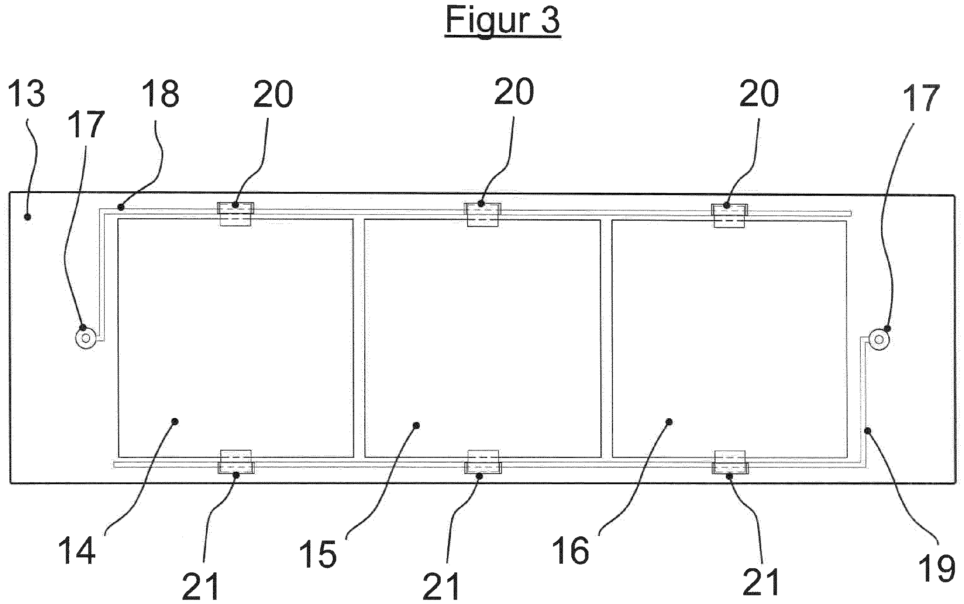

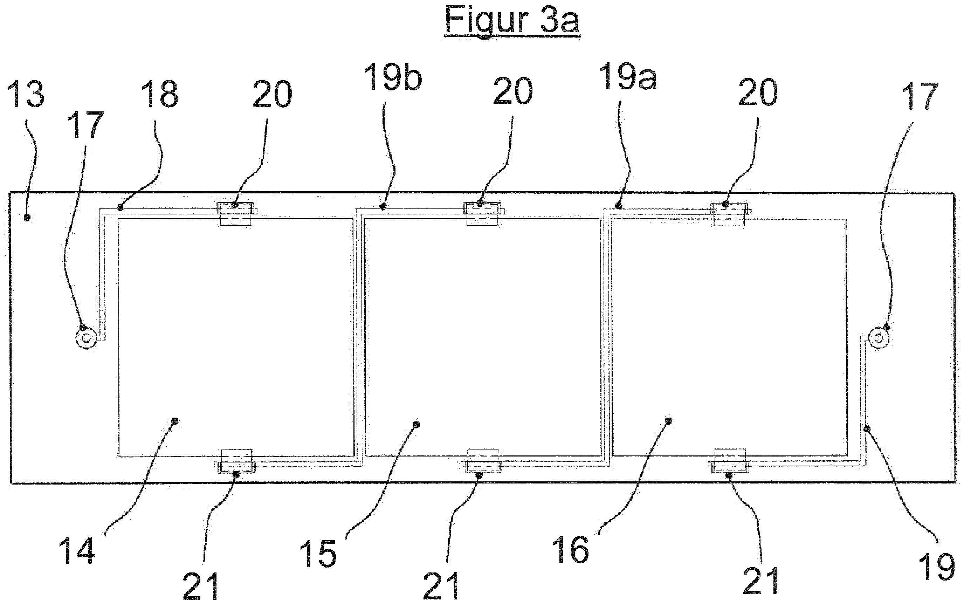

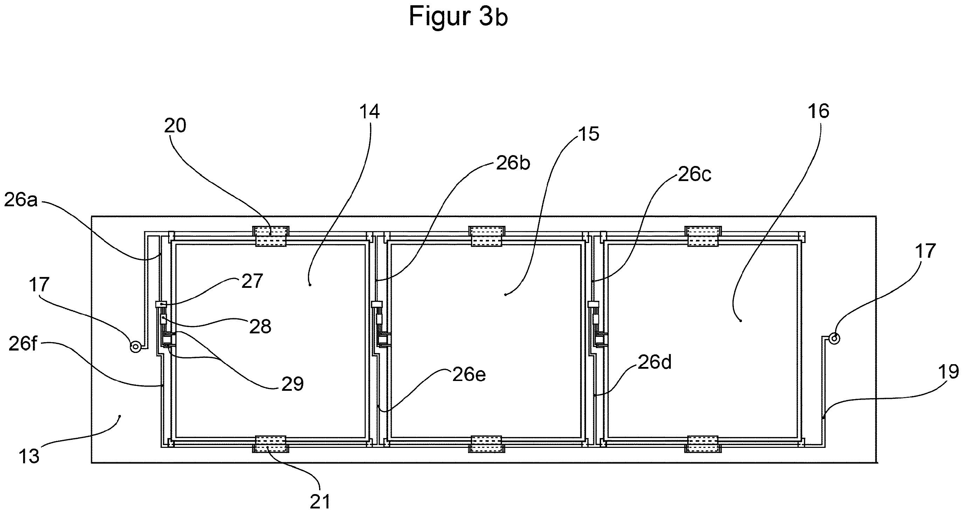

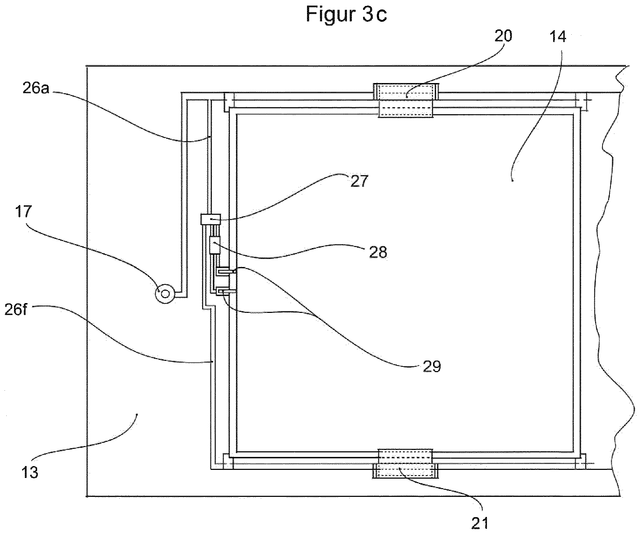

Figur 3 a eine weitere schematisch vereinfachte Draufsicht einer Pendelleuchte von Figur 1 und 2, bei der die OLED-Panels in Serie geschaltet sind;
Figur 3b eine weitere schematisch vereinfachte Draufsicht auf eine Variante einer erfindungsgemäßen Pendelleuchte;
Figur 3c einen vergrößerten Teilausschnitt aus der Ansicht von Figur 3 b;

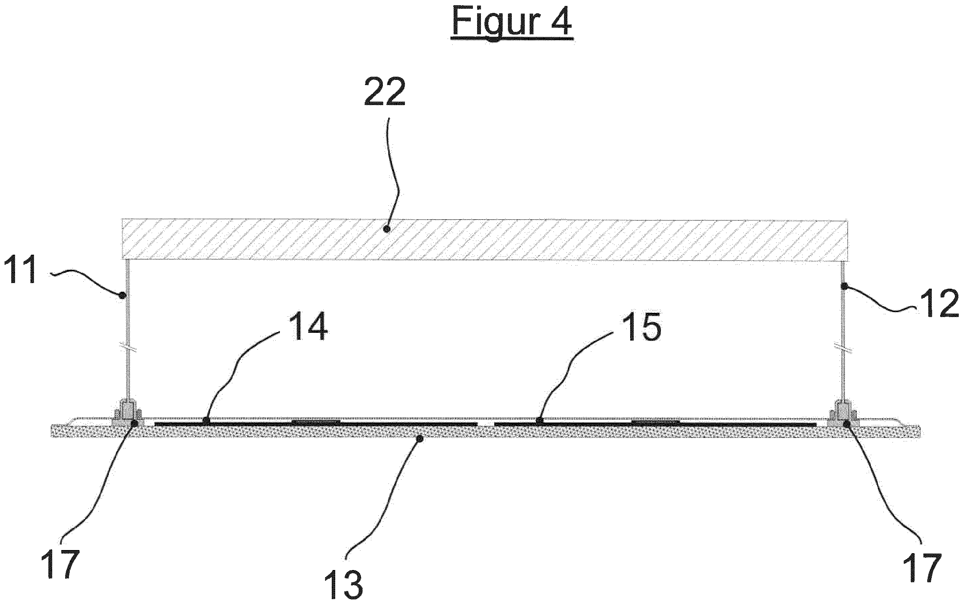

Figur 4 eine schematisch vereinfachte Seitenansicht einer beispielhaften erfindungsgemäßen Pendelleuchte;

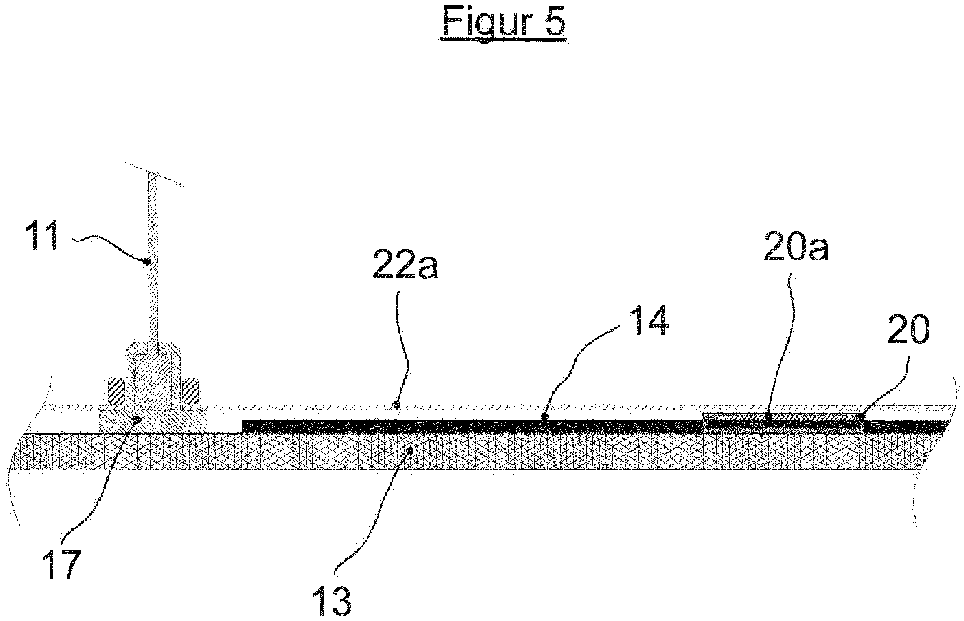

Figur 5 eine vergrößerte Detailansicht eines Ausschnitts aus der Seitenansicht von Figur 4;

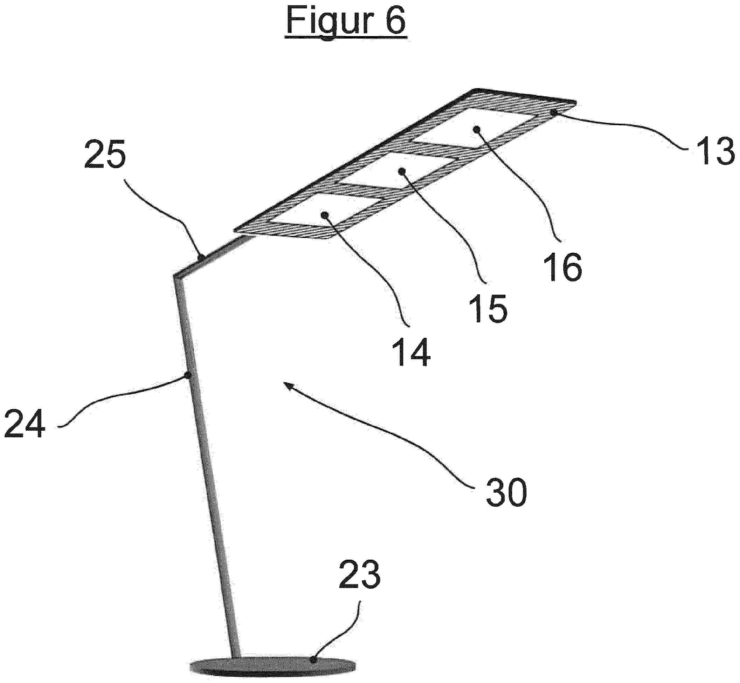

Figur 6 eine schematisch vereinfachte perspektivische Ansicht einer beispielhaften erfindungsgemäßen Tischleuchte;

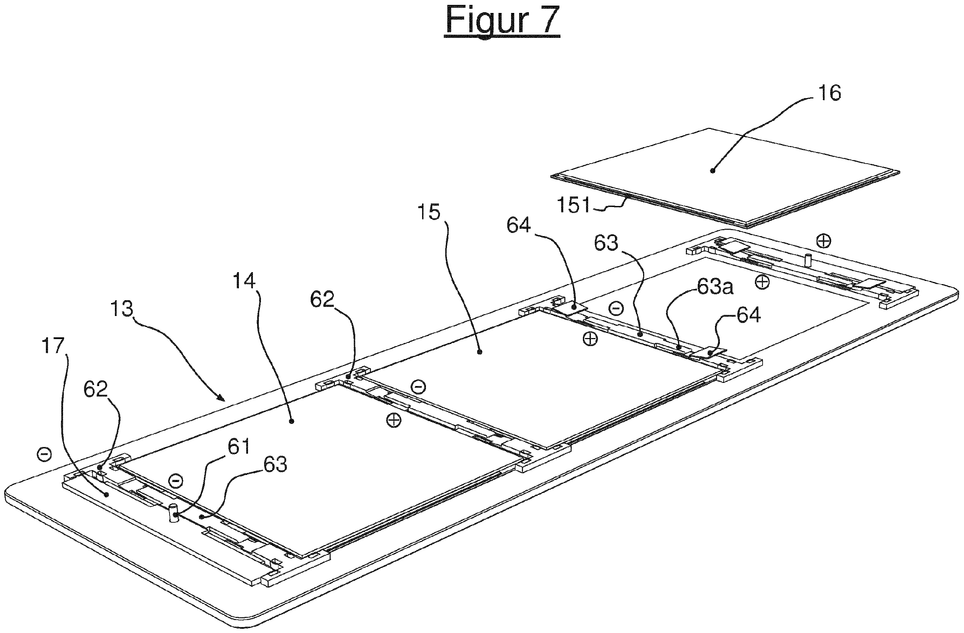

Figur 7 eine perspektivische Ansicht einer beispielhaften Leuchte gemäß einer weiteren alternativen Variante der vorliegenden Erfindung;
Figur 7 a einen vergrößerten Detailausschnitt aus der Darstellung gemäß Figur 7;

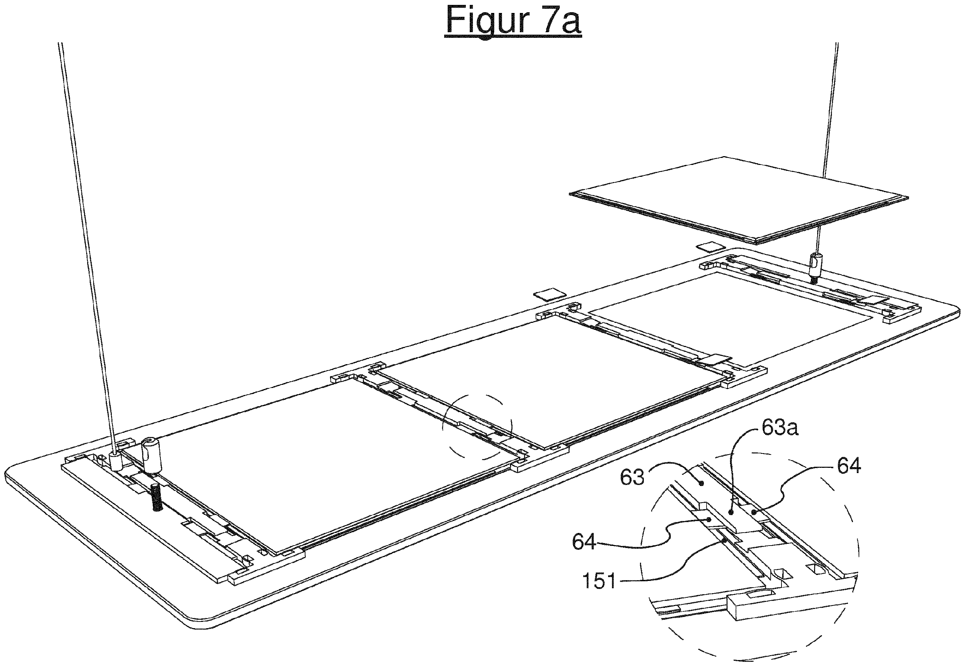

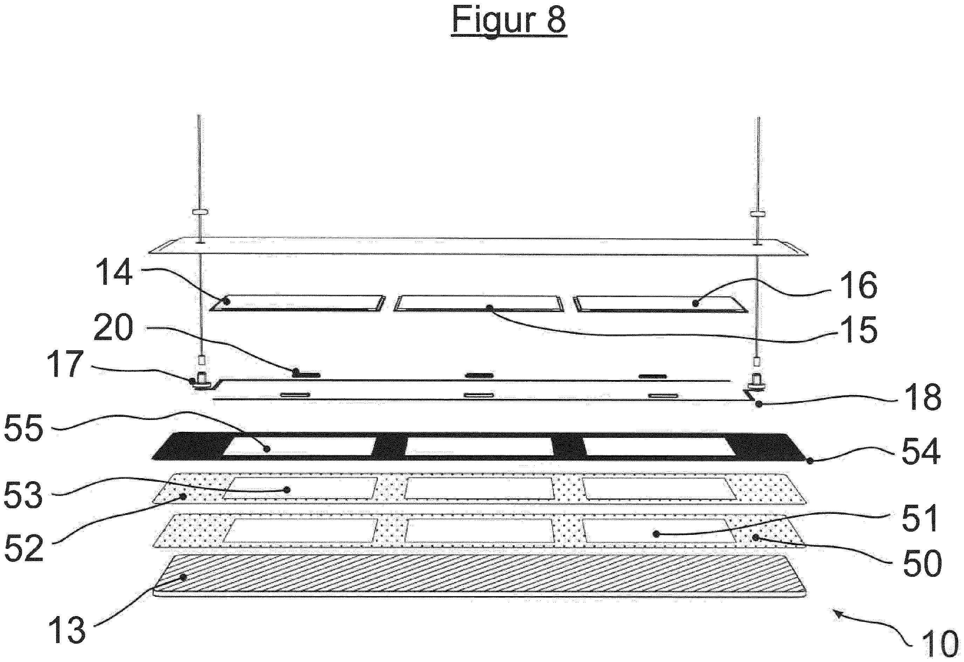

Figur 8 eine perspektivische Explosionsdarstellung einer weiteren beispielhaften erfindungsgemäßen Leuchte, bei der es sich um eine Pendelleichte handelt;

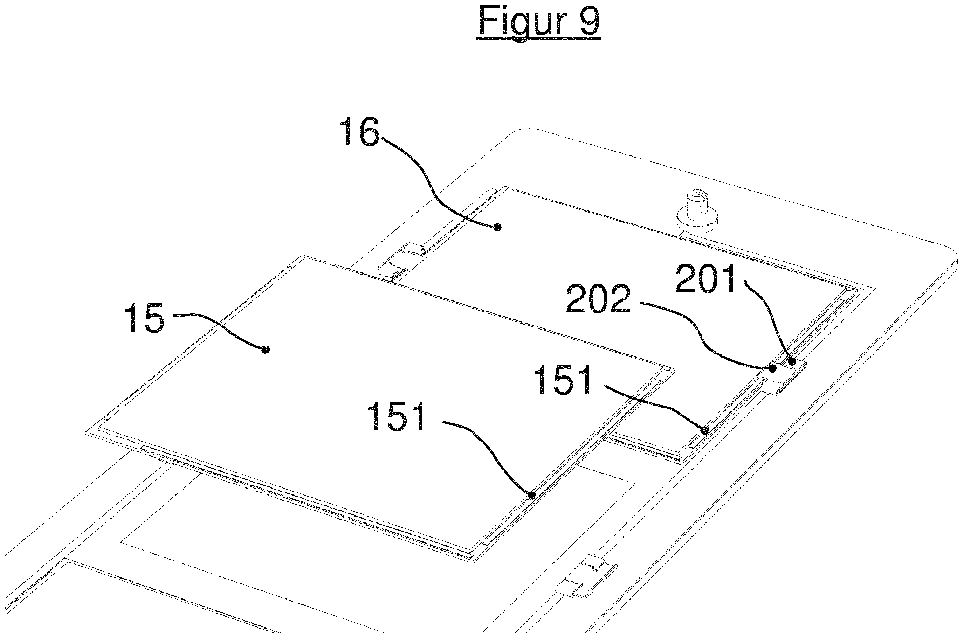

Figur 9 eine perspektivische Detailansicht einer beispielhaften erfindungsgemäßen Pendelleuchte gemäß dem Ausführungsbeispiel der Figuren 1 bis 5;

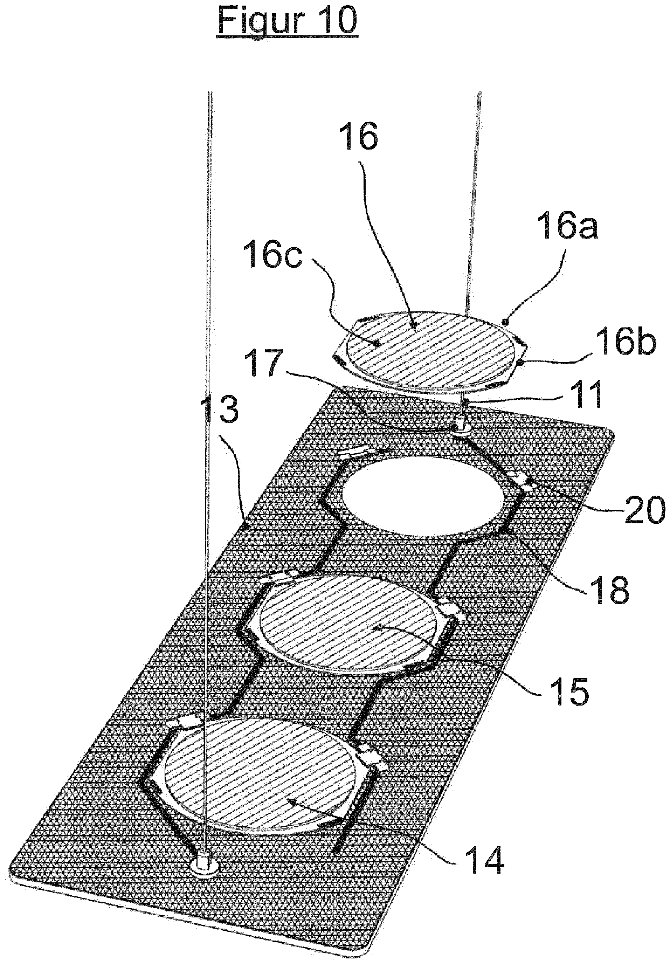

Figur 10 eine Ansicht einer alternativen erfindungsgemäßen Leuchte, bei der die OLED-Panels eine andere Umrissform haben.

Zunächst wird auf die Figuren 1 bis 3 Bezug genommen und anhand dieser wird die prinzipielle Gestaltung einer erfindungsgemäßen Leuchte mit OLED-Panels als Leuchtmittel beispielhaft erläutert. Bei dieser Variante handelt es sich um eine Pendelleuchte 10, die an einer Decke eines Raumes aufgehängt werden kann. Dazu weist die Leuchte zwei Aufhängungen 11, 12 mit Abstand voneinander auf, die auch für die Unterbringung der elektrischen Leitungen für die Spannungsversorgung der Leuchte genutzt werden können, wie weiter unten noch im Detail näher erläutert wird. Die Leuchte umfasst eine Trägerplatte 13 mit einem im wesentlichen rechteckigen Grundriss, so dass sich zwei Längsseiten und zwei Querseiten ergeben. Die Grundrissform ist jedoch innerhalb weiter Bereiche variierbar und die rechteckige langgestreckte Form soll hier nur beispielhaft vorgestellt werden.

Figur 2 zeigt, dass auf der Oberseite der rechteckigen Trägerplatte 13 mehrere ebenfalls rechteckige, hier nahezu quadratische OLED-Panels 14, 15, 16 aufgebracht sind, die auf der Trägerplatte 13 befestigt sind und die in einer Reihe jeweils mit Abstand zueinander und in Längsrichtung der Trägerplatte 13 gesehen nebeneinander angeordnet sind. Die Anzahl der OLED-Panels, deren Umrissform und deren Anordnung auf der Trägerplatte ist in weiten Bereichen variierbar, beispielsweise in Abhängigkeit von der Größe und Umrissform der Trägerplatte 13 sowie auch abhängig von dem Anwendungszweck der Leuchte sowie von lichttechnischen Parametern wie zum Beispiel der gewünschten Beleuchtungscharakteristik, Beleuchtungsstärke etc.

Figur 3 zeigt eine schematisch vereinfachte Draufsicht der Pendelleuchte der Figuren 1 und 2, aus der man das grundsätzliche Prinzip der Kontaktierung der auf der Trägerplatte 13 angebrachten OLED-Panels 14, 15, 16 erkennen kann. Von je einem Kontaktflansch 17 ausgehend, der im Bereich der jeweiligen Aufhängung an der Trägerplatte 13 angebracht sein kann, sind Leiterbahnen 18, 19 vorgesehen, die beispielsweise auf die Trägerplatte 13 aufgedruckt werden können. Die eine Leiterbahn 18 führt von dem in der Zeichnung linken Kontaktflansch 17 ,der dem plus-Pol entspricht, jeweils zu Kontaktschuhen 20, von denen je einer an jedem der drei OLED-Panels 14, 15, 16 angebracht wird und somit den plus-Pol des jeweiligen OLED-Panels kontaktiert. Entsprechend führt von dem in der Zeichnung rechten Kontaktflansch 17, der dem minus-Pol entspricht, eine Leiterbahn 19 zu je einem weiteren Kontaktschuh 21 jedes OLED-Panels, der jeweils den minus-Pol des OLED-Panels kontaktiert. Jedes der drei OLED-Panels 14, 15, 16 wird somit von jeweils zwei Kontaktschuhen 20, 21 kontaktiert, von denen jeweils einer dem plus-Pol entspricht und jeweils einer dem minus-Pol, wobei sich die beiden Kontaktschuhe 20, 21 jedes OLED-Panels beispielsweise an diesem jeweils gegenüber liegen können, so wie dies in der Zeichnung Figur 3 dargestellt ist. Über nur zwei Kontaktflansche 17, die dem minus-Pol bzw. dem plus-Pol entsprechen, sowie jeweils von diesen ausgehenden Leiterbahnen können somit alle auf der Trägerplatte 13 angebrachten OLED-Panels der Leuchte kontaktiert werden.

Bei der Ausführungsform von Figur 3 sind die OLED-Panels parallel geschaltet. Eine weitere alternative Ausführungsform zeigt die Figur 3a, bei der die OLED-Panels in Reihe geschaltet sind und die Leiterbahnen entsprechend jeweils vom Kontaktschuh 21 des minus-Pols des einen OLED-Panels zum Kontaktschuh 20 des plus-Pols des anderen OLED-Panels verlaufen.

Figuren 3b und 3c zeigen eine schematisch vereinfachte Draufsicht einer alternativen Variante einer Pendelleuchte der Figuren 1 und 2, aus der man ein mögliches Prinzip der Kontaktierung der auf der Trägerplatte 13 angebrachten OLED-Panels 14, 15, 16 erkennen kann. Von je einem Kontaktflansch 17 ausgehend, der im Bereich der jeweiligen Aufhängung an der Trägerplatte 13 angebracht sein kann, sind Leiterbahnen 18, 19 vorgesehen, die beispielsweise auf die Trägerplatte 13 aufgedruckt werden können. Die eine Leiterbahn 18 führt von dem in der Zeichnung linken Kontaktflansch 17, der dem plus-Pol entspricht, jeweils zu mehreren Zweigleitungen 26 a, 26 b, 26 c, von denen je eine zu jeweils einem der drei OLED-Panels 14, 15, 16 führt. In jeder dieser Zweigleitungen 26 a, 26 b, 26 c ist jeweils eine Konstantstromquelle 27 der OLED vorgeschaltet, sowie eine Überwachungselektronikschaltung 28. Entsprechend führt von dem in der Zeichnung rechten Kontaktflansch 17, der dem minus-Pol entspricht, eine Leiterbahn 19 auf der Trägerplatte zu den OLED-Panels, von der dann wiederum drei Zweigleitungen 26 d, 26 e, 26 f zu der Konstantstromquelle 27 jeweils eines OLED-Panels abgehen. Von jeder Konstantstromquelle 27 führen dann über die Überwachungselektronikschaltung 28 jeweils die beiden Versorgungsleitungen für beide Pole zu den beiden Kontakten 29 des jeweiligen OLED-Panels. Auf diese Weise sind die drei OLED-Panels 14, 15, 16 parallel geschaltet und werden mit einem konstanten Strom versorgt.

Jedes der drei OLED-Panels 14, 15, 16 wird von jeweils zwei beispielsweise einander etwa gegenüber liegenden Klemmvorrichtungen 20, 21 auf der Trägerplatte 13 lösbar befestigt, so wie dies in der Zeichnung Figur 3 dargestellt ist. Über nur zwei Kontaktflansche 17, die dem minus-Pol bzw. dem plus-Pol entsprechen, sowie jeweils von diesen ausgehenden Leiterbahnen können alle auf der Trägerplatte 13 angebrachten OLED-Panels der Leuchte in Parallelschaltung kontaktiert werden.

Die Spannungsversorgung der Kontaktflansche 17 kann wiederum bei einer Pendelleuchte wie dies in Figur 4 dargestellt ist über die Aufhängungen 11, 12 der Leuchte erfolgen. Dazu wird beispielsweise von einem elektronischen Netzteil 22 ausgehend jeweils eine Zuleitung durch jede der beiden Aufhängungen 11, 12 hindurch geführt, die dann jeweils an ihrem unteren der Trägerplatte 13 zugewandten Ende im Bereich des jeweiligen Kontaktflansches 17 jeweils mit der auf der Trägerplatte aufgebrachten Leiterbahn 18 bzw. 19 einen elektrischen Kontakt herstellt. In dem Beispiel gemäß Figur 4 sind nur zwei OLED-Panels 14, 15 auf der Trägerplatte angeordnet, im Übrigen entspricht der Aufbau der Deckenpendelleuchte aber im wesentlichen demjenigen gemäß Figur 3.

Einen vergrößerten Detailausschnitt aus Figur 4 im linken Bereich zeigt die Figur 5. Dort kann man die elektrische Zuleitung im Bereich der Aufhängung 11 erkennen, die am unteren Ende elektrisch leitend und bevorzugt nach außen hin isoliert mit dem Kontaktflansch 17 in Kontakt tritt, welcher wiederum auf der Trägerplatte 13 befestigt wird, zum Beispiel durch Aufkleben, Aufschrauben oder andere geeignete Techniken. Der Kontaktflansch 17 kann mit seiner Kontaktfläche auf eine Leiterbahn 18, 19 aufgelötet sein, was in Figur 5 nicht dargestellt ist, wobei die Leiterbahn in der Regel im Verhältnis zu den Abmessungen des Kontaktflansches 17 sehr dünn sein kann.

In Figur 5 erkennt man weiterhin einen Teil eines OLED-Panels 14 sowie einen der Kontaktschuhe 20, über den dann der Strom von der Leiterbahn zum entsprechenden Pol des OLED-Panels 14 geleitet wird. Der Kontaktschuh 20 wird auf der Trägerplatte 13 durch geeignete Methoden befestigt, beispielsweise wird er auf die Trägerplatte 13 aufgeklebt und auf die Leiterbahn aufgelötet. Außerdem hat der Kontaktschuh eine Art Klemmvorrichtung beispielsweise mit einem etwa plattenförmigen Klemmteil, welches über das OLED-Panel 14 geschoben werden kann und dadurch das OLED-Panel 14 auf der Trägerplatte sicher festhält. Diese Klemmvorrichtung kann beispielsweise lösbar sein, so dass man das OLED-Panel bei Bedarf zu Revisionszwecken austauschen kann. Der Kontaktschuh hat weiterhin ein beispielsweise plattenförmiges Kontaktmittel, zum Beispiel eine Platine 20 a, die wie man in Figur 5 erkennt, auf dem OLED-Panel aufliegt und dieses kontaktiert. Der Kontaktschuh 20 erfüllt somit zwei Funktionen, zum einen hält er das OLED-Panel an der Trägerplatte 13 fest und zum anderen versorgt er das OLED-Panel mit Spannung, die er wiederum von der elektrischen Leiterbahn 18, 19 (siehe Figur 3) abgreift, welche auf der oberseitigen Fläche der Trägerplatte 13 zum Kontaktflansch 17 führt. Damit die OLED-Panels 14, 15, 16 auf der Oberseite der Trägerplatte 13 nicht für den Betrachter sichtbar sind, kann man eine beispielsweise etwa plattenförmige Abdeckung 22 a vorsehen, die beispielsweise an ihren äußeren Enden an der Trägerplatte gehalten ist (siehe Figur 4) und die mit etwas Abstand oberhalb der Trägerplatte 13 verläuft und die OLED-Panels und die Kontaktschuhe 20 abdeckt. Diese Abdeckung 22 a kann zum Beispiel aus einem dünnen Blech aus Metall bestehen oder dergleichen und sie sorgt für ein ästhetisch ansprechenderes Erscheinungsbild der Leuchte.

In der Figur 6 ist ein alternatives Ausführungsbeispiel zu Figur 1 dargestellt, das andere Leuchtentypen zeigen, bei dem der oben beschriebene Aufbau, das heißt die Art der Anordnung von OLED-Panels auf einer Trägerplatte und deren Kontaktierung, nach dem gleichen Grundprinzip der vorliegenden Erfindung erfolgen kann. Figur 6 zeigt eine Tischleuchte 30 mit einem Leuchtenfuß 23, einem Standrohr 24, einem von dessen oberen Ende in einem Winkel ausgehenden Leuchtenarm 25 in Form eines Auslegers und einem an dem Leuchtenarm auskragend befestigten Leuchtenteil, welches eine Trägerplatte 13 mit OLED-Panels 14, 15, 16 aufweist. Wie man sieht kann auch hier beispielsweise eine im Umriss etwa rechteckige Trägerplatte 13 vorgesehen sein, auf der wiederum beispielsweise in einer Reihe angeordnet mehrere im Umriss zum Beispiel rechteckige OLED-Panels angebracht sind, deren Lichtaustritt nach unten hin erfolgt. Pendelleuchten 10 des in Figur 1 gezeigten Typs und Tischleuchten 30 des in Figur 6 gezeigten Typs können also einen analogen Aufbau zeigen und somit Teil einer Leuchtenfamilie sein.

Nachfolgend wird auf die Figuren 7 und 7 a Bezug genommen und anhand dieser perspektivischen Darstellung wird ein weiteres alternatives Ausführungsbeispiel einer erfindungsgemäßen Leuchte näher erläutert. Bei dieser Variante ist die Kontaktierung der OLED-Panels etwas anders gelöst als bei dem Ausführungsbeispiel gemäß den Figuren 3 bis 5. Gleiche Bauelemente sind jedoch in Figur 7 mit den gleichen Bezugszeichen benannt wie in den zuvor beschriebenen Beispielen. Auch bei der Variante gemäß Figur 7 ist eine im Umriss rechteckige langgestreckte Trägerplatte 13 vorgesehen, die zumindest in dem Bereich, in dem das Licht nach unten hin abgegeben wird aus einem transparenten oder transluzenten Material, insbesondere aus Glas oder Acrylglas besteht. Auf diese Trägerplatte 13 werden mehrere im Umriss rechteckige OLED-Panels 14, 15, 16 aufgebracht. Die Licht abstrahlende Seite der OLED-Panels ist hier nach unten hin und zur Trägerplatte 13 hin gerichtet, so dass die OLED-Panels ihr Licht durch die Trägerplatte hindurch nach unten hin abstrahlen. Hier handelt es sich daher um eine direkt strahlende Leuchte.

Die Befestigung der OLED-Panels 14, 15, 16 auf der Trägerplatte 13 ist lösbar, so dass der Vorteil besteht, dass ein nicht mehr funktionsfähiges OLED-Panel bei Bedarf ausgetauscht werden kann. Diese lösbare Befestigung geschieht über eine Klemmverbindung. In der Zeichnung Figur 7 sind die beiden linken OLED-Panels 14, 15 in der befestigten Position dargestellt, während das rechte OLED-Panel 16 noch nicht befestigt ist und in einer explodierten Ansicht dargestellt ist.

Im Bereich der Befestigung der Leuchte, beispielsweise einer Aufhängung, wenn es sich um eine Pendelleuchte handelt, wobei diese Befestigung hier nur andeutungsweise durch die Gewindestifte 61 dargestellt ist, befindet sich jeweils ein Kontaktflansch 17. Dieser Kontaktflansch 17 ist hier flach, stabförmig, elektrisch leitend, erstreckt sich in Querrichtung der Trägerplatte 13 und liegt auf dieser oberseitig auf. Um das befestigte OLED-Panel in eine akkurate Befestigungsposition zu bringen sind jeweils an den vier Ecken eines OLED-Panels 14, 15, 16 auf der Trägerplatte Positionierelemente 62 angebracht, die rechtwinklige Anlagenkanten haben für die OLED-Panels. Die Kontaktschuhe sind hier zweiteilig ausgebildet und umfassen Klemmelemente 63, die aus einem isolierenden Material bestehen können sowie kleinere platinenartige Kontaktelemente 64, die aus einem elektrisch gut leitenden Material bestehen, in der Regel aus Metall wie zum Beispiel Kupfer oder dergleichen. Die Kontaktelemente 64 sind bei dem rechten OLED-Panel 16 zu erkennen, wo sie separat dargestellt sind, während sie bei dem linken OLED-Panel 14 teils verdeckt sind und daher schlecht erkennbar sind. Die Kombination aus den Klemmelementen 63, die in der Regel auf der Trägerplatte 13 festgelegt sind und den platinenartigen Kontaktelementen 64 erlaubt die doppelte Funktion des gleichzeitigen Kontaktierens und Verklemmens des OLED-Panels 14, 15, 16 auf der Trägerplatte 13.

Dazu werden die Kontaktelemente 64 wie in Figur 7 bei dem rechten OLED-Panel 16 angedeutet einerseits unter zur Trägerplatte 13 beabstandete Fortsätze 63 a der Klemmelemente 63 geschoben. Dabei kommen die Kontaktelemente 64 gleichzeitig mit leistenförmigen oder zungenartigen Flächen 151 in Kontakt, die sich entlang einer Kante des OLED-Panels erstrecken und durch einen Versprung an diesen abgesetzt sind. Diese leistenförmigen Flächen 151 stellen die Kontaktleisten des OLED-Panels 14, 15, 16 dar und sind entweder als Anode oder als Kathode ausgebildet. So befinden sich bei den in Figur 7 gezeigten OLED-Panels die Anode und die Kathode jeweils an einander gegenüber liegenden Seitenkanten der OLED, wobei das OLED-Panel auf der Trägerplatte 13 so positioniert wird, dass sich Anode und Kathode jeweils in Querrichtung der Trägerplatte 13 erstrecken. Wenn ein Kontaktelement 64 eingeschoben wird, dann kontaktiert es gleichzeitig auf der einen Seite (z.B. links) die Kathode eines OLED-Panels 14 und auf der anderen Seite (z.B. rechts) die Anode des benachbarten OLED-Panels 15, so dass sich bei dieser Variante eine Reihenschaltung der OLED-Panels 14, 15, 16 ergibt. Grundsätzlich würde ein Kontaktelement 64 dabei genügen, jedoch sind aus Gründen der Symmetrie jeweils zwei dieser Kontaktelemente 64 jeweils zwischen zwei OLED-Panels 15, 16 angeordnet wie man in Figur 7 erkennen kann. Da bei der Kontaktierung das Kontaktelement 64 unter den Fortsatz 63 a des Klemmelements 63 geschoben wird und da das Kontaktelement 64 von oben auf die leistenförmige Fläche 151 des OLED-Panels 16 drückt, wird das OLED-Panel dadurch klemmend auf der Trägerplatte 13 gehalten und kann nicht mehr nach oben hin abheben. Da die OLED-Panels mit ihren leistenförmigen Flächen entlang der seitlichen Ränder sehr filigran ausgebildet sind, hat es sich zur Vereinfachung der Handhabung als vorteilhaft erwiesen, Klemmelemente 63 und Kontaktelemente 64 als separate Bauelemente auszubilden. (Die Gesamtheit aus Klemmelement 63 und Kontaktelement 64 wir in der vorliegenden Anmeldung als "Kontaktschuh" bezeichnet.) So wird die Handhabung bei der Montage erleichtert und die Kontaktelemente 64 werden von oben her etwa in Querrichtung der Trägerplatte 13 eingeschoben, so wie dies in Figur 7 angedeutet ist. Sie werden dabei unter die Fortsätze 63 a und gleichzeitig über die leistenförmigen Flächen 151 geschoben, so dass sich die Klemmwirkung im Grunde erst durch das Zusammenwirken der Kontaktelemente 64 und der Klemmelemente 63 entfaltet. Bei dem außen in der Reihe liegenden OLED-Panel 14 treten die Kontaktelemente 64, die unter die Klemmelemente 63 geschoben werden, einerseits mit einer Elektrode (hier Kathode) des linken OLED-Panels 14 in Kontakt und andererseits auf ihrer linken Seite mit den Kontaktflanschen 17, so dass der Strom von den Kontaktflanschen 17 abgenommen wird und gleichzeitig das linke OELD-Panel kontaktiert und auf seiner einen Seite klemmend auf der Trägerplatte 13 befestigt wird. Der Kontaktflansch 17 kann beispielsweise auf die Trägerplatte 13 geklebt oder geschraubt werden. Die Klebeverbindung hat den Vorteil, dass sie keine Bohrung in die beispielsweise aus Glas bestehende Trägerplatte 13 erfordert.

In der Figur 7a, die einen vergrößerten Detailausschnitt aus Figur 7 an der gekennzeichneten Stelle zeigt, kann man ein bereits befestigtes Kontaktelement 64 in der Klemmposition erkennen, in der es unter den Fortsatz 63 a des Klemmelements 63 geschoben ist. Man sieht, dass das Kontaktelement 64 etwas breiter ist als der Fortsatz 63 a, so dass es, wenn es unter dem Fortsatz 63 a liegt, an beiden Seiten über diesen hinausragt. Diese beiden Überstände kommen auf den leistenförmigen Flächen 151 des OELD-Panels 15 zur Auflage und halten dieses somit auf der Trägerplatte 13. Man kann in Figur 7 a auch gut erkennen, dass ein einziges Kontaktelement 64 auf diese Weise jeweils die leistenförmigen Flächen 151 von zwei zueinander benachbarten OLED-Panels gleichzeitig kontaktiert, wobei bei einem OLED-Panel der plus-Pol und bei dem anderen der minus-Pol kontaktiert wird.

Nachfolgend wird auf die Figur 8 Bezug genommen und anhand dieser ein weiteres Ausführungsbeispiel der vorliegenden Erfindung näher erläutert. Die Darstellung zeigt schematisch vereinfacht eine Pendelleuchte 10 schräg von oben, bei der das Licht nach unten hin austritt. Die Leuchte weist eine Trägerplatte 13 auf, die an ihrer Rückseite (entspricht in diesem Fall der Oberseite), die dem Betrachter bei aufgehängter Leuchte abgewandt ist, eine mehrfache Bedruckung aufweist. Der grundsätzliche konstruktive Aufbau der Pendelleuchte 10 gemäß Figur 8 kann demjenigen der in dem zuvor beschriebenen Ausführungsbeispiel gemäß den Figuren 1 bis 5 entsprechen, so dass wegen der Details bezüglich der Kontaktierung der OLED-Panels, der aufgedruckten Leiterbahnen, der Aufhängung der Leuchte etc. auf die Beschreibung der Figuren 1 bis 5 Bezug genommen werden kann.

Figur 8 zeigt die mehrfache Bedruckung der Pendelleuchte 10. Dabei wird die Rückseite der Trägerplatte zunächst mit einer ersten Bedruckung 50 versehen, bei der drei etwa rechteckige Flächen 51 ausgespart sind, da in diesen ausgesparten Flächenbereichen später die OLED-Panels 14, 15, 16 aufgebracht werden. Diese erste Bedruckung bildet somit eine Art virtuellen Rahmen für die OLED-Panels. Die Bedruckung ist sehr dünnschichtig, kann zum Beispiel durch Siebdruck aufgebracht werden und besteht beispielsweise aus keramischen Pigmenten, die elektrisch isolierend sind. Diese Pigmente können eine helle Farbe aufweisen, zum Beispiel sind sie weiß. Da nur die etwa rechteckigen Bereiche für die spätere Anbringung der OLED-Panels ausgespart sind und die Trägerplatte 13 in ihren übrigen Bereichen flächig und vergleichsweise dicht bedruckt wird, ergeben sich in den bedruckten Bereichen 50 um die OLED-Panels herum und zwischen den OLED-Panels Flächen die die Trägerplatte 13, die weitgehend transparent/lichtdurchlässig ist, blickdicht machen. Somit kann man in diesen Flächen 50 später Klemmvorrichtungen 20 für die OLED-Panels, Kontaktflansche 17 im Bereiche der Aufhängungen der Leuchte 10, Leiterbahnen 18 für die Stromversorgung der OLED-Panels und elektronische Bauelemente wie die Konstantstromquelle 27, die Überwachungselektronikschaltung 28 und dergleichen unterbringen, die dann von der Unterseite der Trägerplatte 13 her, an der das Licht abgegeben wird, nicht mehr erkennbar sind.

Im Rahmen der Entwicklung der erfindungsgemäßen Leuchte wurde festgestellt, dass eine Bedruckung 50 allein mit hellen Pigmenten, wenn sie sehr dünnschichtig ist, gegebenenfalls nicht ausreichend ist, um die gewünschte Blickdichtigkeit in ausreichendem Maße sicherzustellen. Deshalb ist es in einem solchen Fall vorteilhaft, wenn anschließend noch eine zweite Bedruckung 52 erfolgt, bei der die gleichen Bereiche 53 ausgespart werden können wie bei der ersten Bedruckung 50. Diese zweite Bedruckung 52 kann beispielsweise erneut mit einem hellen, z.B. weißen keramischen Pigment erfolgen und ist bevorzugt ebenfalls sehr dünnschichtig, beispielsweise im µm-Bereich oder noch dünner.

In dem Ausführungsbeispiel gemäß Figur 8 ist noch eine weitere dritte Bedruckung 54 vorgesehen, die im Anschluss an die zweite Bedruckung 52 aufgebracht wird und bei der auch wieder etwa rechteckige Bereiche 55 ausgespart werden, in denen anschließend die OLED-Panels angebracht werden. Bei dieser dritten Bedruckung handelt es sich in dem Beispiel um eine dunkle, z.B. schwarze oder graue Bedruckung, mittels derer zum einen die gewünschte Blickdichtigkeit in hohem Maße erzielt wird, sofern in dieser Hinsicht die doppelte helle vorhergehende Bedruckung 50, 52 nicht ausreicht, wobei die dritte Bedruckung 54 noch den weiteren vorteilhaften Effekt haben kann, dass sie einen höheren Kontrast und somit eine bessere optische Anmutung der durch die mehrfache Bedruckung abgedeckten Bereiche erreicht. Nach der Aufbringung der Bedruckung in hier drei Schichten können dann beispielsweise die Leiterbahnen 18 an den vorgesehenen Stellen ebenfalls aufgedruckt werden, wozu ein elektrisch leitendes Pigment zum Beispiel mit einem Silberanteil verwendet werden kann. Danach erfolgt dann die weitere Montage der Leuchte mit Aufbringung der Kontaktflansche 17, der Klemmvorrichtungen 20 und der OLED-Panels 14, 15, 16, wozu auch auf die Ausführungen zu den Figuren 1 bis 5 verwiesen wird.

Nachfolgend wird unter Bezugnahme auf die Detailansicht gemäß Figur 9 die Funktion der Klemmvorrichtungen 20 bei einer Leuchte des erfindungsgemäßen Typs, wie er beispielsweise in den Figuren 1 bis 5 beschrieben ist, näher erläutert. In der Darstellung gemäß Figur 9 ist eines der OLED-Panels 15 im noch nicht montierten Zustand dargestellt und ein anderes OLED-Panel 16 daneben ist im montierten Zustand gezeigt. Dadurch wird die jeweils unterschiedliche Stellung der Klemmvorrichtungen 20 deutlich. Die Klemmvorrichtungen 20 bestehen im Prinzip aus zwei gegeneinander verschieblichen Teilen, nämlich einer Spange 201, die eine feste Position auf der Trägerplatte 13 hat. Diese Spange 201 dient als Aufnahme für einen Schieber 202, der in etwa horizontaler Richtung, das heißt etwa parallel zur Ebene des OLED-Panels gegenüber der Spange 201 veschiebbar ist, wobei die Spange den Schieber übergreift und dieser dadurch bei seiner Bewegung geführt ist. Bei dem nicht montierten OLED-Panel 15 befindet sich der Schieber 202 in einer zurückgezogenen Position. Nach dem Auflegen des OLED-Panels auf die Trägerplatte wird der Schieber 202 der Klemmvorrichtung 20 vorgeschoben und schiebt sich dadurch über eine zungenartige oder leistenförmige Fläche 151 des OLED-Panels, die sich seitlich entlang einer Kante des OLED-Panels erstrecken kann und beispielsweise gegenüber der oberseitigen Fläche des OLED-Panels durch einen Versprung abgesetzt ist, also niedriger ist als das OLED-Panels in den übrigen Bereichen. Durch diesen Vorgang des Vorschiebens des Schiebers 202 wird die leistenförmige Fläche 151 des OLED-Panels übergriffen und so wird das OLED-Panel klemmend gehalten, da der Schieber 202 über die Leiste 151 greift, so dass das OLED-Panel nicht mehr nach oben abheben kann.

Nachfolgend wird unter Bezugnahme auf die Figur 10 ein weiteres alternatives Ausführungsbeispiel der vorliegenden Erfindung näher erläutert, bei dem OLED-Panels mit einer anderen Umrissform vorgesehen sind. Es sind hier drei OLED-Panels 14, 15, 16 vorhanden, bei denen die Lichtabgabefläche 16 c einen runden Umriss hat. Die Randbereiche dieser OLED-Panels 14, 15, 16 die über die Klemmvorrichtungen 20 befestigt werden, verlaufen in einigen Abschnitten 16 a des Umfangs teils bogenförmig, in anderen Abschnitten 16 b hingegen gerade. Entsprechend der etwas anderen Umrissform der OLED-Panels 14, 15, 16 ist die Position der Klemmvorrichtungen 20 auf der Trägerplatte 13 etwas anders als bei den zuvor beschriebenen Ausführungsbeispielen. Die Kontaktierung erfolgt hier beispielsweise in den Randbereichen der OLED-Panels mit Hilfe von jeweils zwei Klemmvorrichtungen mit Kontaktelementen 20 pro OLED-Panel, wobei beispielsweise für benachbarte OLED-Panels jeweils die Kontaktelemente gleicher Polarität parallel geschaltet sein können und über Leiterbahnen 18 auf der Trägerplatte miteinander elektrisch verbunden sind, wobei diese Leiterbahnen 18, zu den Kontaktflanschen 17 verlaufen, die sich jeweils im Bereich der Aufhängung 11 der Leuchte befinden.

### Bezugszeichenliste

10 Pendelleuchte
11 Aufhängung
12 Aufhängung
13 Trägerplatte
14 OLED-Panel
15 OLED-Panel
151 leistenförmige Fläche
16 OLED-Panel
16 a bogenförmige Abschnitte des Umfangs
16 b gerade Abschnitte des Umfangs
16 c Lichtabgabefläche
17 Kontaktflansch
18 Leiterbahn
19 Leiterbahn
19 a Leiterbahn
19 b Leiterbahn
20 Klemmvorrichtung
20 a Platine
201 Spange
202 Schieber
21 Kontaktschuh
22 Netzteil
22 a plattenförmige Abdeckung
23 Leuchtenfuß
24 Standrohr
25 Leuchtenarm
26 a Zweigleitung
26 b Zweigleitung
26 c Zweigleitung
26 d Zweigleitung
26 e Zweigleitung
26 f Zweigleitung
27 Konstantstromquelle
28 Überwachungselektronikschaltung
29 Kontakte
30 Tischleuchte
50 erste Bedruckung
51 ausgesparte Flächen
52 zweite Bedruckung
53 ausgesparte Bereiche
54 dritte Bedruckung
55 ausgesparte Bereiche
61 Gewindestifte
62 Positionierelemente
63 Klemmelemente
63 a Fortsätze
64 Kontaktelemente

## Patentansprüche

1. Leuchte umfassend wenigstens ein flächig auf einer mindestens teilweise lichtdurchlässigen Trägerplatte (13) aufliegendes als OLED-Panel (14, 15, 16) ausgebildetes OLED-Leuchtmittel, wobei wenigstens zwei jeweils einem OLED-Panel (14, 15, 16) zugeordnete Kontaktschuhe (20, 21) auf der der Licht abgebenden Seite abgewandten Rückseite der Trägerplatte (13) befestigt sind, welche jeweils Mittel zur Kontaktierung jeweils eines Pols des OLED-Panels umfassen,
wobei wenigstens ein Kontaktschuh (20, 21) eine Befestigungsvorrichtung aufweist, mittels derer das OLED-Panel (14, 15, 16) an der Trägerplatte (13) befestigt wird, vorzugsweise eine Klemmvorrichtung, mittels derer das OLED-Panel klemmend befestigt wird,
**dadurch gekennzeichnet, dass** zwei oder mehrere etwa in einer Reihe angeordnete OLED-Panels (14, 15, 16) auf der der Licht abstrahlenden Seite abgewandten Rückseite der mindestens teilweise lichtdurchlässigen Trägerplatte (13) angeordnet sind und dass wenigstens ein Kontaktflansch (17) auf oder an der Trägerplatte (13) befestigt ist, der mit einer auf der Trägerplatte aufgebrachten Leiterbahn (18, 19) in leitendem Kontakt steht, welche von dem Kontaktflansch aus zu einem oder mehreren jeweils den OLED-Panels (14, 15, 16) zugeordneten Kontaktschuhen (20, 21) führt.

2. Leuchte nach Anspruch 1, **dadurch gekennzeichnet, dass** wenigstens ein Kontaktschuh (20, 21) als Mittel zur Kontaktierung eines Pols des OLED-Panels (14, 15, 16) ein plattenförmiges Element, insbesondere eine Platine (20 a) aufweist.

3. Leuchte nach einem der Ansprüche 1 oder 2, **dadurch gekennzeichnet, dass** wenigstens ein Kontaktschuh (20, 21) durch Aufkleben auf eine dem OLED-Panel (14, 15, 16) zugewandte Fläche aus Glas oder Kunststoffglas der Trägerplatte (13) auf dieser befestigt ist.

4. Leuchte nach einem der Ansprüche 1 bis 3, **dadurch gekennzeichnet, dass** auf die Trägerplatte (13) Leiterbahnen (18, 19) aufgebracht sind und wenigstens ein Kontaktschuh (20, 21) auf eine Leiterbahn unter Herstellung einer leitenden Verbindung aufgelötet ist.

5. Leuchte nach einem der Ansprüche 1 bis 4, **dadurch gekennzeichnet, dass** wenigstens ein Kontaktflansch (17), der mit wenigstens einer auf der Trägerplatte (13) aufgebrachten Leiterbahn (18, 19) in leitendem Kontakt steht, im Bereich der Aufhängung (11, 12) oder Befestigung der Leuchte (10) angeordnet ist.

6. Leuchte nach einem der Ansprüche 1 bis 5, **dadurch gekennzeichnet, dass** diese eine Pendelleuchte (10) ist und wenigstens ein Kontaktflansch (17) im Bereich der Aufhängung (11, 12) der Leuchte angeordnet ist, wobei eine elektrische Versorgungsleitung der Leuchte durch die Aufhängung der Leuchte zu dem Kontaktflansch führt und mit diesem an ihrem unteren Ende in elektrisch leitender Verbindung steht.

7. Leuchte nach einem der Ansprüche 1 bis 6, **dadurch gekennzeichnet, dass** mindestens die dem OLED-Panel (14, 15, 16) zugewandte und mit diesem lösbar zu verbindende Fläche der lichtdurchlässigen Trägerplatte (13) aus Glas oder Kunststoffglas, insbesondere Acrylglas besteht und die Trägerplatte (13) an ihrer Licht abstrahlenden Seite mindestens in Teilbereichen mattiert ist, insbesondere durch Ätzen, Sandstrahlen, Schleifen, Lasern, Fräsen oder dergleichen oder die Trägerplatte (13) an der der Licht abstrahlenden Seite abgewandten Rückseite mindestens in Teilbereichen beschichtet oder bedruckt ist.

8. Leuchte nach einem der Ansprüche 1 bis 7, **dadurch gekennzeichnet, dass** an der der Licht abstrahlenden Seite abgewandten Seite der Trägerplatte (13) eine plattenförmige Abdeckung (22 a) vorgesehen ist, die die OLED-Panels (14, 15, 16) abdeckt.

9. Leuchte nach einem der Ansprüche 1 bis 8, **dadurch gekennzeichnet, dass** jeweils ein Pol von in einer Reihe angeordneten OLED-Panels von je einer gemeinsamen Leiterbahn (18, 19) kontaktiert wird und/oder mehrere OLED-Panels über Kontaktschuhe (20, 21) und Leiterbahnen (18, 19) in einer Parallelschaltung oder in einer Reihenschaltung kontaktiert werden.

10. Leuchte nach einem der Ansprüche 1 bis 9, **dadurch gekennzeichnet, dass** diese eine Pendelleuchte (10), Hängeleuchte, Deckenanbauleuchte, Deckeneinbauleuchte, Wandanbauleuchte, Wandeinbauleuchte, Stehleuchte oder Tischleuchte (30) ist oder diese eine mobile Leuchte, eine Spiegelleuchte, eine Möbelleuchte oder ein beleuchtbares Möbelelement, eine Außenleuchte, Bodeneinbauleuchte, Bodenanbauleuchte, Straßenleuchte, Orientierungsleuchte, eine Leuchte für eine Notbeleuchtung oder eine Hinweisleuchte ist.

11. Leuchte nach Anspruch 9, **dadurch gekennzeichnet, dass** die Trägerplatte (13) an der der Licht abstrahlenden Seite abgewandten Rückseite in denjenigen Teilbereichen beschichtet, beklebt, mattiert oder bedruckt ist, in denen sich Befestigungselemente, insbesondere für die Aufhängung oder Halterung der Leuchte, und/oder Kontaktelemente für die OLED-Panels und/oder Leiterbahnen befinden, wobei insbesondere die Trägerplatte (13) an der der Licht abstrahlenden Seite abgewandten Rückseite mit wenigstens einer Schicht rahmenartig flächig bedruckt, beklebt, mattiert oder beschichtet ist, wobei diese Bedruckung, Beklebung, Mattierung oder Beschichtung die Licht abgebenden Flächen, auf denen das oder die OLED-Panels (14, 15, 16) aufgebracht werden, ausspart.

12. Leuchte nach Anspruch 11, **dadurch gekennzeichnet, dass** die Trägerplatte (13) an ihrer der Licht abstrahlenden Seite abgewandten Rückseite wenigstens eine Bedruckung (50, 52, 54) Beklebung oder Beschichtung mit einem elektrisch isolierenden Material, insbesondere mit keramischen Pigmenten aufweist und/oder die Trägerplatte (13) an ihrer der Licht abstrahlenden Seite abgewandten Rückseite wenigstens eine Bedruckung (50, 52) oder Beschichtung mit hellen, insbesondere etwa weißen Pigmenten oder Farbstoffen aufweist.

13. Leuchte nach einem der Ansprüche 11 oder 12, **dadurch gekennzeichnet, dass** die der Licht abstrahlenden Seite abgewandte Rückseite der Trägerplatte (13) wenigstens zwei Schichten einer in mehreren aufeinanderfolgenden Verfahrensschritten aufgebrachte Bedruckung (50, 52, 54), Beklebung, Mattierung oder Beschichtung aufweist, wobei die Bedruckung, Beklebung, Mattierung oder Beschichtung mehrerer übereinander liegender Schichten vorzugsweise jeweils etwa deckungsgleich ist und die Licht abgebenden Flächen der OLED-Panels jeweils ausspart, wobei insbesondere die der Licht abstrahlenden Seite abgewandte Rückseite der Trägerplatte eine zweifache, dreifache oder mehrfache Bedruckung (50, 52, 54), Beklebung oder Beschichtung von etwa deckungsgleichen Flächen aufweist, wobei wenigstens eine Bedruckung (50, 52), Beklebung oder Beschichtung mit einem hellen, insbesondere weißen Pigment oder Farbstoff vorgesehen ist und wenigstens eine Bedruckung (54), Beklebung oder Beschichtung mit einem dunklen, insbesondere grauen oder schwarzen Pigment oder Farbstoff vorgesehen ist.

14. Leuchte nach einem der Ansprüche 11 bis 13, **dadurch gekennzeichnet, dass** diese ein Leuchtregal, Leuchtpanel, elektrisches Gerät, Haushaltsgerät, Stadtraummöbel, Fassadenelement, Wandelement, Deckenelement, eine Außenleuchte eines Kraftfahrzeugs oder eine Einbaueinrichtung eines Kraftfahrzeugs, Schienenfahrzeugs, Schiffs oder Flugzeugs ist, oder ein beleuchtbares Teil eines solchen Gegenstands ist.

15. Leuchte nach einem der Ansprüche 1 oder 9, **dadurch gekennzeichnet, dass** wenigstens zwei OLED-Panels über Leiterbahnen (18, 19) in einer Parallelschaltung kontaktiert werden, wobei für jedes OLED-Panel jeweils eine diesem zugeordnete Konstantstromquelle oder ein Strombegrenzer vorgesehen ist und/oder für jedes OLED-Panel jeweils eine Überwachungselektronikschaltung vorgesehen ist, wobei vorzugsweise diese Überwachungselektronikschaltung jeweils im Leitungsweg zwischen Konstantstromquelle oder Strombegrenzer und den Kontakten des OLED-Panels angeordnet ist.

16. Leuchte umfassend wenigstens ein flächig auf einer mindestens teilweise lichtdurchlässigen Trägerplatte (13) aufliegendes als OLED-Panel (14, 15, 16) ausgebildetes OLED-Leuchtmittel, wobei wenigstens zwei jeweils einem OLED-Panel (14, 15, 16) zugeordnete Kontaktschuhe (63, 64) auf der der Licht abgebenden Seite abgewandten Rückseite der Trägerplatte (13) befestigt sind, welche jeweils Mittel zur Kontaktierung jeweils eines Pols des OLED-Panels umfassen,
wobei wenigstens ein Kontaktschuh (63, 64) eine Befestigungsvorrichtung aufweist, mittels derer das OLED-Panel (14, 15, 16) an der Trägerplatte (13) befestigt wird, vorzugsweise eine Klemmvorrichtung, mittels derer das OLED-Panel klemmend befestigt wird,
**dadurch gekennzeichnet, dass** zwei oder mehrere etwa in einer Reihe angeordnete OLED-Panels (14, 15, 16) auf der der Licht abstrahlenden Seite abgewandten Rückseite der mindestens teilweise lichtdurchlässigen Trägerplatte (13) angeordnet sind und dass wenigstens ein Kontaktflansch (17) auf oder an der Trägerplatte (13) befestigt ist, der mit einem auf der Trägerplatte angeordneten Kontaktschuh (63, 64) in leitendem Kontakt steht, welcher wenigstens ein OLED-Panel (14, 15, 16) kontaktiert.

17. Leuchte nach Anspruch 16, **dadurch gekennzeichnet, dass** wenigstens ein Kontaktschuh (63, 64) vorgesehen ist, der jeweils die Kontaktbereiche (151) zweier benachbarter OLED-Panels (14, 15; 15, 16) kontaktiert, wobei bei einem OLED-Panel der plus-Pol und bei dem anderen OLED-Panel der minus-Pol kontaktiert wird.

18. Leuchte nach Anspruch 16 oder 17, **dadurch gekennzeichnet, dass** wenigstens ein Kontaktschuh zweiteilig ausgebildet ist und ein auf der Trägerplatte (63) festlegbares Klemmelement (63) umfasst und wenigstens ein mit dem Klemmelement lösbar verbindbares Kontaktelement (64), welches den Kontaktbereich (151) des (der) OLED-Panels (14, 15, 16) kontaktiert.

19. Leuchte nach einem der Ansprüche 16 bis 18, **dadurch gekennzeichnet, dass** die OLED-Panels (14, 15, 16) sich entlang einer Kante erstreckende etwa leistenförmige oder zungenartige Kontaktbereiche (151) aufweisen und wenigstens ein Kontaktelement im montierten Zustand (64) von oben auf diesen Kontaktbereich (151) drückt und dabei das OLED-Panel gleichzeitig kontaktiert und auf der Trägerplatte (13) festklemmt.

## Claims

1. Lamp comprising at least one OLED light fixture in the form of an OLED panel (14, 15, 16) lying flat on an at least partially light-permeable carrier plate (13), wherein at least two contact shoes (20, 21), each one assigned to an OLED panel (14, 15, 16), are attached to the rear side of the carrier plate (13) facing away from the side emitting the light each having means for contacting one pole of the OLED panel,
wherein at least one contact shoe (20, 21) comprises a fastening device, by means of which the OLED panel (14, 15, 16) is fastened to the carrier plate (13), preferably a clamping device by way of which the OLED panel is fastened in a clamping manner,
**characterised in that** two or more OLED panels (14, 15, 16) arranged in a row, for instance, are arranged on the rear side of the at least partially light-permeable carrier plate (13) facing away from the light-emitting side and **in that** at least one contact flange (17) is fastened on or to the carrier plate (13) which is in conductive contact with a strip conductor (18, 19) which is applied to the carrier plate and leads to one or more contact shoes (20, 21) each assigned to the OLED panels (14, 15, 16).

2. Lamp according to claim 1 **characterised in that** at least one contact shoe (20, 21) comprises a plate-like element, in particular a circuit board (20a) as a means of contacting a pole of the OLED panel (14, 15, 16).

3. Lamp according to any one of claims 1 or 2 **characterised in that** the at least one contact shoe (20, 21) is attached to the carrier plate (13) through adhesion to a glass or synthetic glass surface facing the OLED panel (14, 15, 16) .

4. Lamp according to any one of claims 1 to 3 **characterised in that** strip conductors (18, 19) are applied to the carrier plate (13) and at least one contact shoe (20, 21) is soldered on a strip conductor forming a conductive connection.

5. Lamp according to any one of claims 1 to 4 **characterised in that** at least one contact shoe (17) which is in conductive contact with at least one strip conductor (18, 19) applied to the carrier plate (13) is arranged in the area of the suspension (11, 12) or attachment of the lamp (10).

6. Lamp according to any one of claims 1 to 5 **characterised in that** it is a pendant lamp (10) and at least one contact surface (17) is arranged in the area of the suspension (11, 12) of the lamp, wherein an electrical supply lead of the lamp leads through the suspension of the lamp to the contact surface and at its lower end is in electrically conductive connection therewith.

7. Lamp according to any one of claims 1 to 6 **characterised in that** at least the surface of the light permeable carrier plate (13) facing the OLED panel (14, 15, 16) and detachably connectable therewith, is made of glass or synthetic glass, in particular acrylic glass, and the carrier plate (13) is given a matt finish on its light-emitting side at least in parts, in particular through etching, sand-blasting, grinding, lasering, milling or suchlike, or on the rear side facing away from the light-emitting side the carrier plate (13) is coated or printed at least in partial areas.

8. Lamp according to any one of claims 1 to 7 **characterised in that** on the side of the carrier plate (13) facing away from the light-emitting side a plate-like cover (22a) is provided which covers the OLED panels (14, 15, 16) .

9. Lamp according to any one of claims 1 to 8 **characterised in that** in each case one pole of OLED panels arranged in a row is contacted by one common strip conductor (18, 19) and/or several OLED panels are contacted by means of contact shoes (20, 21) and strip conductors (18, 19) in a parallel circuit or in a series circuit.

10. Lamp according to any one of claims 1 to 9 **characterised in that** this is a pendant lamp (10), suspended lamp, ceiling-connected lamp, incorporated ceiling lamp, wall-connected lamp, incorporated wall lamp, standard lamp or table lamp (30), or this is a portable lamp, a mirror lamp, a furniture lamp or an illuminable furniture element, an outdoor lamp, floor-incorporated lamp, floor-connected lamp, streetlamp, orientation lamp, a lamp for emergency lighting or an indicator lamp.

11. Lamp according to claim 9 **characterised in that** the carrier plate (13), on the rear side facing away from the light-emitting side, is coated, laminated, matted or printed in the partial area where there are fastening elements for the suspension or holder of the lamp and/or contact elements for the OLED panels and/or strip conductors, wherein in particular the carrier plate (13), on the rear side facing away from the light-emitting side, is printed, laminated, matted or coated with at least one layer in a frame-like manner, wherein this printing, lamination, matting or coating omits the light-emitting surfaces on which the OLED panel(s) (14, 15, 16) is/are applied.

12. Lamp according to claim 11 **characterised in that** the carrier plate (13) on its rear side facing away from the light-emitting side has at least one area of printing (50, 52, 54), lamination or coating with an electrically insulating material, more particularly with ceramic pigments, and/or the carrier plate (13) on its rear side facing away from the light-emitting side has at least one area of printing (50, 52) or coating with light, more particularly for example white pigments or dyes.

13. Lamp according to any one of claims 11 or 12 **characterised in that** the rear side of the carrier plate (13) facing away from the light-emitting side has at least two layers of printing (50, 52, 54), lamination, matting or coating applied in several successive processing stages, wherein the printing, lamination, matting or coating is in several, preferably congruent, layers lying one on top of each other, each omitting the light emitting surfaces of the OLED panel, wherein in particular the rear side of the carrier plate facing away from the light-emitting side has dual, triple or multiple printing, (50, 52, 54), lamination or coating of, for example, congruent surfaces, wherein at least one layer of printing, (50, 52), lamination or coating is provided with a light, more particularly, white, pigment or dye and at least one layer of printing (54), lamination or coating is provided with a dark, more particularly grey or black pigment or dye.

14. Lamp according to any one of claims 11 to 13 **characterised in that** this is an illuminated shelf, light panel, electrical device, household device, urban furniture, façade element, wall element, ceiling element, and external light of a motor vehicle, or a built-in device of a motor vehicle, rail-borne vehicle, ship or aircraft or an illuminable part of such an object.

15. Lamp according to any one of claims 1 or 9 **characterised in that** at least two OLED panels are contacted via strip conductors (18, 19) connected in parallel, wherein for each OLED panel one constant current source or current limiter assigned thereto is provided and/or for each OLED panel a monitoring electronic circuit is envisaged wherein preferably this monitoring electronic circuit is arranged in the conductive path between the constant current source or current limiter and the contacts of the OLED panel.

16. Lamp comprising at least one OLED light fixture in the form of an OLED panel (14, 15, 16) lying flat on an at least partially light-permeable carrier plate (13), wherein at least two contact shoes (63, 64) each one assigned to an OLED panel (14, 15, 16) are attached to the rear side of the carrier plate (13) facing away from the side emitting the light each having means for contacting one pole of the OLED panel,
wherein at least one contact shoe (63, 64) comprises a fastening device, by means of which the OLED panel (14, 15, 16) is fastened to the carrier plate (13), preferably a clamping device by way of which the OLED panel is fastened in a clamping manner,
**characterised in that** two or more OLED panels (14, 15, 16), for example connected in a row, are arranged on the rear side of the at least partially light-permeable carrier plate (13) facing away from the light-emitting side and **in that** at least one contact flange (17) is attached on or to the carrier plate (13) which is in conductive contact with a contact shoe (63, 64), arranged on the carrier plate, which contacts at least one OLED panel (14, 15, 16).

17. Lamp according to claim 16 **characterised in that** at least one contact shoe (63, 64) is provided which contacts the contact areas (151) of two adjacent OLED panels (14, 15: 15, 16), wherein in one OLED pole the plus pole and in the other OLED the minus pole is contacted.

18. Lamp according to claim 16 or 17 **characterised in that** at least one contact shoe is designed in two parts and comprises a clamping element (63) fixable to the carrier plate (63) and at least one contact element (64) detachably connectable to the clamping element, which contacts the contact area (151) of the OLED panel (s) (14, 15, 16).

19. Lamp according to any one of claims 16 to 18 **characterised in that** the OLED panels (14, 15, 16) comprises bar or tongue-shaped contact areas (151) extending along one edge and in the assembled state (64) at least one contact element presses from above onto this contact area (151) and simultaneously contacts the OLED panel and clamps it on the carrier plate (13).

## Revendications

1. Lampe comprenant au moins un moyen d'éclairage conçu comme un panneau OLED (14, 15, 16) reposant de façon planaire sur une plaque de support (13) au moins partiellement transparente à la lumière, dans laquelle au moins deux patins de contact (20, 21) attribués respectivement à un panneau OLED (14, 15, 16) sont fixés sur le côté arrière de la plaque de support (13) opposé au côté émettant de la lumière, lesquels comportent respectivement des moyens pour la mise en contact respectivement d'un pôle du panneau OLED,
dans laquelle au moins un patin de contact (20, 21) présente un dispositif de fixation permettant de fixer le panneau OLED (14, 15, 16) à la plaque de support (13), de préférence un dispositif de serrage permettant de fixer le panneau OLED par serrage,
**caractérisée en ce que** deux ou plusieurs panneau OLED (14, 15, 16) disposés approximativement dans une rangée sont disposés sur le côté arrière de la plaque de support (13) au moins partiellement transparente à la lumière opposé au côté émettant de la lumière, et **en ce qu'**au moins une bride de contact (17) est fixée sur ou à la plaque de support (13), laquelle est en contact conducteur avec une piste conductrice (18, 19) appliquée sur la plaque de support, celle-ci menant de la bride de contact vers un ou plusieurs patins de contact (20, 21) respectivement attribués aux panneaux OLED (14, 15, 16).

2. Lampe selon la revendication 1, **caractérisée en ce qu'**au moins un patin de contact (20, 21) présente un élément en forme de plaque, en particulier une platine (20a), en tant que moyen pour la mise en contact d'un pôle du panneau OLED (14, 15, 16).

3. Lampe selon l'une des revendications 1 ou 2, **caractérisée en ce qu'**au moins un patin de contact (20, 21) est fixé par collage à une surface en verre ou en verre plastique de la plaque de support (13) tournée vers le panneau OLED (14, 15, 16).

4. Lampe selon l'une des revendications 1 à 3, **caractérisée en ce que** des pistes conductrices (18, 19) sont appliquées sur la plaque de support (13) et au moins un patin de contact (20, 21) est brasé sur une piste conductrice pour produire une liaison conductrice.

5. Lampe selon l'une des revendications 1 à 4, **caractérisée en ce qu'**au moins une bride de contact (17) en contact conducteur avec au moins une piste conductrice (18, 19) appliquée sur la plaque de support (13) est disposée dans la région de la suspension (11, 12) ou de la fixation de la lampe (10).

6. Lampe selon l'une des revendications 1 à 5, **caractérisée en ce que** celle-ci est une lampe suspendue (10) et **en ce qu'**au moins une bride de contact (17) est disposée dans la région de la suspension (11, 12) de la lampe, dans laquelle une ligne d'alimentation électrique de la lampe mène à la bride de contact à travers la suspension de la lampe tout en étant en contact électriquement conducteur avec celle-ci à son extrémité inférieure.

7. Lampe selon l'une des revendications 1 à 6, **caractérisée en ce qu'**au moins la surface de la plaque de support (13) transparente à la lumière tournée vers le panneau OLED (14, 15, 16) et destinée à être reliée à celui-ci de façon détachable est constituée de verre ou de verre plastique, en particulier de verre acrylique, et **en ce que** la plaque de support (13) est dépolie au moins dans des régions partielles sur son côté émettant de la lumière, en particulier par attaque chimique, par sablage, par ponçage, au laser, par fraisage ou autre, ou **en ce que** la plaque de support (13) est revêtue ou imprimée au moins dans des régions partielles sur le côté arrière opposé au côté émettant de la lumière.

8. Lampe selon l'une des revendications 1 à 7, **caractérisée en ce qu'**un recouvrement en forme de plaque (22a) recouvrant les panneaux OLED (14, 15, 16) est prévu sur le côté de la plaque de support (13) opposé au côté émettant de la lumière.

9. Lampe selon l'une des revendications 1 à 8, **caractérisée en ce qu'**un pôle de panneaux OLED disposés dans une rangée est respectivement en contact avec une piste conductrice (18, 19) commune et/ou **en ce que** plusieurs panneaux OLED sont mis en contact dans un montage en parallèle ou un montage en série par le biais de patins de contact (20, 21) et de pistes conductrices (18, 19).

10. Lampe selon l'une des revendications 1 à 9, **caractérisée en ce que** celle-ci est une lampe suspendue (10), une lampe à suspension, une lampe de plafond encastrée, une lampe de plafond incorporée, une lampe murale encastrée, une lampe murale incorporée, un lampadaire ou une lampe de table (30), ou **en ce que** celle-ci est une lampe mobile, une lampe de miroir, une lampe de meuble ou un élément de meuble éclairable, une lampe d'extérieur, une lampe de sol encastrée, une lampe de sol incorporée, un réverbère, une lampe d'orientation, une lampe pour un éclairage de secours ou une lampe de signalisation.

11. Lampe selon la revendication 9, **caractérisée en ce que** sur le côté arrière opposé au côté émettant de la lumière, la plaque de support (13) est revêtue, recouverte d'un collage, dépolie ou imprimée dans les régions partielles dans lesquelles se trouvent des éléments de fixation, en particulier pour la suspension ou le montage de la lampe, et/ou des éléments de contact por les panneaux OLED et/ou des pistes conductrices, la plaque de support (13) étant en particulier imprimée, recouverte d'un collage, dépolie ou revêtue de façon surfacique à la manière d'un encadrement avec au moins une couche sur le côté arrière opposé au côté émettant de la lumière, sachant que cette impression, ce collage, ce dépolissage ou ce revêtement exclut les surfaces émettant de la lumière, sur lesquelles sont appliqués le ou les panneaux OLED (14, 15, 16).

12. Lampe selon la revendication 11, **caractérisée en ce que** sur son côté arrière opposé au côté émettant de la lumière, la plaque de support (13) présente au moins une impression (50, 52, 54), un collage ou un revêtement avec un matériau électriquement isolant, en particulier avec des pigments céramiques, et/ou **en ce que** sur son côté arrière opposé au côté émettant de la lumière, la plaque de support (13) présente au moins une impression (50, 52) ou un revêtement avec des pigments ou des colorants clairs, en particulier proches du blanc.

13. Lampe selon l'une des revendications 11 ou 12, **caractérisée en ce que** le côté arrière de la plaque de support (13) opposé au côté émettant de la lumière présente au moins deux couches d'une impression (50, 52, 54), d'un collage, d'un dépolissage ou d'un revêtement de plusieurs couches superposées, appliquées en plusieurs étapes de traitement consécutives, dans laquelle l'impression, le collage, le dépolissage ou le revêtement de plusieurs couches superposées est de préférence respectivement approximativement coïncident et exclut respectivement les surfaces du panneau OLED émettant de la lumière, dans laquelle le côté arrière de la plaque de support opposé au côté émettant de la lumière présente en particulier une impression (50, 52, 54), un collage ou un revêtement double, triple ou multiple de surfaces approximativement coïncidentes, dans laquelle au moins une impression (50, 52), un collage ou un revêtement est prévu avec un pigment ou un colorant clair, en particulier blanc, et au moins une impression (54), un collage ou un revêtement est prévu avec un pigment ou un colorant foncé, en particulier gris ou noir.

14. Lampe selon l'une des revendications 11 à 13, **caractérisée en ce que** celle-ci est une étagère lumineuse, un panneau lumineux, un appareil électrique, un appareil électroménager, un meuble d'espace urbain, un élément de façade, un élément mural, un élément de plafond, une lampe d'extérieur d'un véhicule automobile ou un dispositif encastrable d'un véhicule automobile, d'un véhicule ferroviaire, d'un bateau ou d'un avion, ou une partie éclairable d'un tel objet.

15. Lampe selon l'une des revendications 1 ou 9, **caractérisée en ce qu'**au moins deux panneaux OLED sont en contact dans un montage en parallèle par le biais de pistes conductrices (18, 19), dans laquelle, une source de courant constant ou un limiteur de courant est prévu(e) respectivement pour chaque panneau OLED, et/ou **en ce qu'**un circuit électronique de surveillance est prévu respectivement pour chaque panneau OLED, ce circuit électronique de surveillance étant respectivement disposé sur la trajectoire entre la source de courant constant ou le limiteur de courant et les contacts du panneau OLED.

16. Lampe comprenant au moins un moyen d'éclairage conçu comme un panneau OLED (14, 15, 16) reposant de façon planaire sur une plaque de support (13) au moins partiellement transparente à la lumière, dans laquelle au moins deux patins de contact (63, 64) attribués respectivement à un panneau OLED (14, 15, 16) sont fixés sur le côté arrière de la plaque de support (13) opposé au côté émettant de la lumière, lesquels comportent respectivement des moyens pour la mise en contact respectivement d'un pôle du panneau OLED,
dans laquelle au moins un patin de contact (63, 64) présente un dispositif de fixation permettant de fixer le panneau OLED (14, 15, 16) à la plaque de support (13), de préférence un dispositif de serrage permettant de fixer le panneau OLED par serrage,
**caractérisée en ce que** deux ou plusieurs panneau OLED (14, 15, 16) disposés approximativement dans une rangée sont disposés sur le côté arrière de la plaque de support (13) au moins partiellement transparente à la lumière opposé au côté émettant de la lumière, et **en ce qu'**au moins une bride de contact (17) est fixée sur ou à la plaque de support (13), laquelle est en contact conducteur avec un patin de contact (63, 64) disposé sur la plaque de support, lequel est en contact avec au moins un panneau OLED (14, 15, 16).

17. Lampe selon la revendication 16, **caractérisée en ce qu'**il est prévu au moins un patin de contact (63, 64), lequel est respectivement en contact avec les régions de contact (151) de deux panneaux OLED (14, 15 ; 15, 16) voisins, sachant que sur un panneau OLED, le pôle positif est mis en contact et sur l'autre panneau OLED, le pôle négatif est mis en contact.

18. Lampe selon la revendication 16 ou 17, **caractérisée en ce qu'**au moins un patin de contact est conçu en deux parties et comporte un élément de serrage (63) susceptible d'être fixé sur la plaque de support (63), ainsi qu'un élément de contact (64) en contact avec la région de contact (151) du/des panneau (x) OLED (14, 15, 16) et apte à être relié de façon amovible à l'élément de serrage.

19. Lampe selon l'une des revendications 16 à 18, **caractérisée en ce que** les panneaux OLED (14, 15, 16) présentent des régions de contact (151) en forme de barrettes ou du genre langues s'étendant le long d'un bord, et **en ce qu'**au moins un élément de contact (64) appuie par au-dessus sur cette région de contact (151) dans l'état monté, tout en étant simultanément en contact avec le panneau OLED et en serrant celui-ci contre la plaque de support (13).
